# EUROPÄISCHE PATENTANMELDUNG

(11) **EP 0 987 754 A2**
(43) Veröffentlichungstag der Anmeldung: **22.03.2000**
(21) Anmeldenummer: 99117722.1
(22) Anmeldetag: 08.09.1999
(51) Int. Cl.: H01L 21/8242

(54) **Herstellungsverfahren für einen Grabenkondensator mit einem Isolationskragen**

(30) Priorität: 17.09.1998 DE 19842665
(71) Anmelder: SIEMENS AKTIENGESELLSCHAFT, 80333 München (DE)
(72) Erfinder: Schrems, Martin, Dr., 01465 Langebrück (DE); Arnold, Norbert, Chestnut-Ridge, NY 10952 (US)

(57) **Zusammenfassung**

Die vorliegende Erfindung schafft ein Verfahren zur Herstellung eines Grabenkondensators, insbesondere zur Verwendung in einer Halbleiter-Speicherzelle (100), mit einem Isolationskragen (168'; 168'') mit den Schritten: Bereitstellen eines Substrats (101); Bilden eines Grabens (108) in dem Substrat (101); Vorsehen einer ersten Schicht (177) auf der Grabenwand; Vorsehen einer zweiten Schicht (178) auf der ersten Schicht (177) auf der Grabenwand; Füllen des Grabens (108) mit einem ersten Füllmaterial (152); Entfernen des ersten Füllmaterials (152) aus dem oberen Bereich des Grabens (108) zum Definieren eines Kragenbereichs; Entfernen der zweiten Schicht (178) aus dem oberen Bereich des Grabens (108); Entfernen des ersten Füllmaterials (152) aus dem unteren Bereich des Grabens (108); Entfernen der ersten Schicht (177) aus dem oberen Bereich des Grabens (108); lokales Oxidieren des oberen Bereichs des Grabens (108) zum Schaffen des Isolationskragens (168'; 168''); Entfernen der ersten und zweiten Schicht (177; 178) aus dem unteren Bereich des Grabens; Bilden einer dielektrischen Schicht (164) im unteren Bereichs des Grabens (108) und auf der Innenseite des Isolationskragens (168'; 168''); und Füllen des Grabens (108) mit einem leitenden zweiten Füllmaterial (161).

## Beschreibung

Die vorliegende Erfindung betrifft ein Herstellungsverfahren für einen Grabenkondensator mit einem Isolationskragen.

Integrierte Schaltungen (ICs) oder Chips verwenden Kondensatoren zum Zwecke der Ladungsspeicherung. Ein Beispiel eines IC, welcher Kondensatoren zum Speichern von Ladungen verwendet, ist ein Speicher-IC, wie z.B. ein Chip für einen dynamischen Schreib-/Lesespeicher mit wahlfreiem Zugriff (DRAM). Der Ladungszustand ("0" oder "1") in dem Kondensator repräsentiert dabei ein Datenbit.

Ein DRAM-Chip enthält eine Matrix von Speicherzellen, welche in Form von Zeilen und Spalten verschaltet sind. Üblicherweise werden die Zeilenverbindungen als Wortleitungen und die Spaltenverbindungen als Bitleitungen bezeichnet. Das Auslesen von Daten von den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor enthält zwei Diffusionsbereiche, welche durch einen Kanal getrennt sind, oberhalb dessen ein Gate angeordnet ist. Abhängig von der Richtung des Stromflusses bezeichnet man den einen Diffusionsbereich als Drain und den anderen als Source. Die Bezeichnungen "Drain" und "Source" werden hier hinsichtlich der Diffusionsbereiche gegenseitig austauschbar verwendet. Die Gates sind mit einer Wortleitung verbunden, und einer der Diffusionsbereiche ist mit einer Bitleitung verbunden. Der andere Diffusionsbereich ist mit dem Kondensator verbunden. Das Anlegen einer geeigneten Spannung an das Gate schaltet den Transistor ein, ermöglicht einen Stromfluß zwischen den Diffusionsbereichen durch den Kanal, um so eine Verbindung zwischen dem Kondensator und der Bitleitung zu bilden. Das Ausschalten des Transistors trennt diese Verbindung, indem der Stromfluß durch den Kanal unterbrochen wird.

Die in dem Kondensator gespeicherte Ladung baut sich mit der Zeit aufgrund eines inhärenten Leckstroms ab. Bevor sich die Ladung auf einen unbestimmten Pegel (unterhalb eines Schwellwerts) abgebaut hat, muß der Speicherkondensator aufgefrischt werden.

Das fortlaufende Bestreben nach Verkleinerung der Speichervorrichtungen fördert den Entwurf von DRAMs mit größerer Dichte und kleinerer charakteristischer Größe, d.h. kleinerer Speicherzellenfläche. Zur Herstellung von Speicherzellen, welche eine geringeren Oberflächenbereich besetzen, werden kleinere Komponenten, beispielsweise Kondensatoren, verwendet. Jedoch resultiert die Verwendung kleinerer Kondensatoren in einer erniedrigten Speicherkapazität, was wiederum die Funktionstüchtigkeit und Verwendbarkeit der Speichervorrichtung widrig beeinflussen kann. Beispielsweise erfordern Leseverstärker einen ausreichenden Signalpegel zum zuverlässigen Auslesen der Information in den Speicherzellen. Das Verhältnis der Speicherkapazität zur Bitleitungskapazität ist entscheidend bei der Bestimmung des Signalpegels. Falls die Speicherkapazität zu gering wird, kann dieses Verhältnis zu klein zur Erzeugung eines hinreichenden Signals sein. Ebenfalls erfordert eine geringere Speicherkapazität eine höhere Auffrischfrequenz.

Ein Kondensatortyp, welcher üblicherweise in DRAMs verwendet wird, ist ein Grabenkondensator. Ein Grabenkondensator hat eine dreidimensionale Struktur, welche in dem Siliziumsubstrat ausgebildet ist. Eine Erhöhung des Volumens bzw. der Kapazität des Grabenkondensators kann durch tieferes Ätzen in das Substrat erreicht werden. In diesem Fall beweirkt die Steigerung der Kapazität des Grabenkondensators keine Vergrößerung der von der Speicherzelle belegte Oberfläche.

Ein üblicher Grabenkondensator enthält einen in das Substrat geätzten Graben. Dieser Graben wird typischerweise mit n⁺-dotiertem Polysilizium gefüllt, welches als eine Kondensatorelektrode dient (auch als Speicherkondensator bezeichnet). Optionellerweise wird eine zweite Kondensatorelektrode (auch als "vergrabene Platte" bezeichnet) durch Ausdiffundieren von n⁺-Dotierstoffen von einer Dotierstoffquelle in einen Bereich des Substrats, welcher den unteren Abschnitts des Grabens umgibt, gebildet. Ein n⁺-dotiertes Silikatglas, wie z.B. ein mit Arsen dotiertes Silikatglas (ASG), dient dabei als die Dotierstoffquelle. Ein Speicherdielektrikum, welches Nitrid enthält, wird üblicherweise zur Isolation der zwei Kondensatorelektroden verwendet.

In dem oberen Bereich des Grabens wird ein dielektrischer Kragen erzeugt, um einen Leckstrom von dem Kondensatoranschluß mit der vergrabenen Platte zu verhindern. Das Speicherdielektrikum in dem oberen Bereich des Grabens, wo der Kragen zu bilden ist, wird vor dessen Bildung entfernt. Die Entfernung des Nitrids verhindert einen vertikalen Leckstrom entlang des Kragens.

Obwohl auf beliebige Grabenkondensatoren anwendbar, werden sowohl die vorliegende Erfindung als auch die ihr zugrundeliegende Problematik nachstehend in bezug auf einen in einer DRAM-Speicherzelle verwendeten Grabenkondensator erläutert. Solche Speicherzellen werden in integrierten Schaltungen (ICs), wie beispielsweise Speichern mit wahlfreiem Zugriff (RAMs), dynamischen RAMs (DRAMs), synchronen DRAMs (SDRAMs), statischen RAMs (SRAMs), embedded DRAMs und Nur-Lese-Speichern (ROMs) verwendet. Andere integrierte Schaltungen enthalten Logikvorrichtungen, wie z.B. programmierbare Logikarrays (PLAs), anwenderspezifische ICs (ASICs), Mischlogik/ Speicher-ICs (eingebettete DRAMs) oder sonstige Schaltungsvorrichtungen. Üblicherweise wird eine Vielzahl von ICs auf einem Halbleitersubstrat, wie z.B. einem Siliziumwafer, parallel hergestellt. Nach der Verarbeitung wird der Wafer zerteilt, um die ICs in eine Vielzahl individueller Chips zu separieren. Die Chips werden dann in Endprodukte verpackt, beispielsweise zur Verwendung in Verbraucherprodukten, wie z.B. Computersystemen, zellulären Telefonen, persönlichen digitalen Assistenten (PDAs) und weiteren Produkten. Zu Diskussionszwecken wird die Erfindung hinsichtlich der Bildung einer einzelnen Speicherzelle beschrieben.

Zur Erläuterung der der vorliegenden Erfindung zugrundeliegenden Problematik werden nachstehend zunächst einige übliche Grabenkondensator-DRAM-Speicherzellen sowie deren Herstellungsverfahren erläutert.

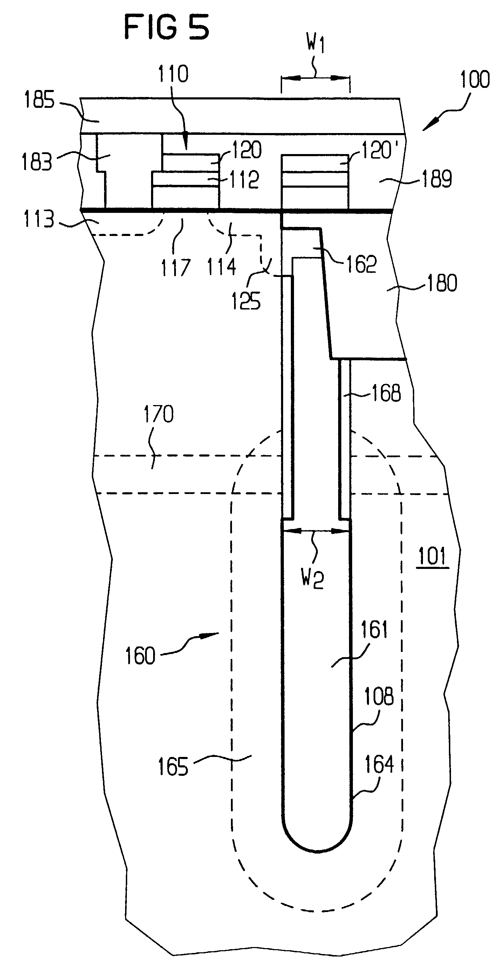

Mit Bezug auf Fig. 5 ist eine übliche Grabenkondensator-DRAM-Speicherzelle 100 gezeigt. Sie umfaßt einen Grabenkondensator 160, welcher in einem Substrat 101 gebildet ist. Das Substrat ist leicht mit p-Typ-Dotierstoffen (p⁻), wie z.B. Bor (B), dotiert. Der Graben 108 ist üblicherweise mit Polysilizium 161 gefüllt, das mit n-Dotierstoffen (n⁺), wie z.B. Arsen (As) oder Phosphor (P), dotiert ist. Optionellerweise ist eine vergrabene Platte 165, welche beispielsweise mit As dotiert ist, in dem Substrat 101 in der Umgebung des unteren Bereichs des Grabens 108 vorgesehen. Das As wird z.B. von einer Dotierstoffquelle, wie z.B. ASG, in das Siliziumsubstrat 101 diffundiert, die auf den Seitenwänden des Grabens 108 gebildet ist. Das Polysilizium 161 und die vergrabene Platte 165 dienen als die Kondensatorelektroden.

Ein Speicherdielektrikum 164 trennt diese Kondensatorelektroden. Die Speicherdielektrikumschicht 164 umfaßt beispielsweise Nitrid oder Nitrid/Oxid. Oxid/Nitrid/Oxid oder eine sonstige dielektrische Schicht oder ein Stapel von dielektrischen Schichten, wie z.B. Oxid, nitrides Oxid oder NONO, sind ebenfalls verwendbar.

Die DRAM-Speicherzelle 100 weist ebenfalls einen Transistor 110 auf. Der Transistor 110 umfaßt ein Gate 112 und Diffusionsbereiche 113 und 114. Die Diffusionsbereiche 113, 114, welche durch einen Kanal 117 getrennt sind, werden durch Implantieren von n-Typ-Dotierstoffen, wie z.B. Phosphor (P) gebildet. Ein Kondensatoranschlußdiffusionsbereich 125, welcher als "Kondensatoranschluß" bezeichnet wird, verbindet den Grabenkondensator 160 mit dem Transistor 110. Der Kondensatoranschlußdiffusionsbereich 125 wird durch Ausdiffundieren von Dotierstoffen von dem Graben-Polysilizium 161 durch eine vergrabene Brücke 162 gebildet.

Ein Kragen 168 ist an einem oberen Bereich des Grabens 108 gebildet. Mit dem oberem Bereich des Grabens 108 ist der Abschnitt gemeint, welcher den Kragen 168 enthält, und mit dem unteren Bereich des Grabens ist der Abschnitt unterhalb des Kragens 168 gemeint. Der Kragen 168 verhindert einen Leckstrom des Kondensatoranschlusses 162 zur vergrabenen Platte 165. Der Leckstrom ist unerwünscht, weil er die Haltezeit der Speicherzelle verschlechtert, was die Auffrischfrequenz erhöht und daher die Funktionstüchtigkeit beeinträchtigt.

Eine vergrabene Wanne 170 mit n-Typ-Dotierstoffen, wie z.B. P oder As, ist unterhalb der Oberfläche des Substrats 101 vorgesehen. Die Spitzenkonzentration der Dotierstoffe in der vergrabenen n-Wanne 170 liegt etwa an der Unterseite des Kragens 168. Typischerweise ist die vergrabene Wanne 170 im Vergleich zur vergrabenen Platte 165 leicht dotiert. Die vergrabene Wanne 170 dient zur Verbindung der vergrabenen Platten 165 der DRAM-Speicherzellen in der Speicherzellenmatrix.

Die Aktivierung des Transistors 110 durch Anlegen geeigneter Spannungen an dem Gate 112 und der Bitleitung 185 schafft eine Verbindung zum Grabenkondensator 160. Im allgemeinen ist das Gate 112 mit einer Wortleitung 120 verbunden, und der Diffusionsbereich 113 ist mit einer Bitleitung 185 in der DRAM-Matrix über einen Kontakt 183 verbunden. Die Bitleitung 185 ist von den Diffusionsbereichen 113, 114 über eine dazwischenliegende dielektrische Zwischenschicht 189 isoliert.

Ein schmaler Isolationsgraben (STI-Isolation) 180 ist vorgesehen, um die DRAM-Speicherzelle 100 von anderen Speicherzellen oder sonstigen elektrischen Vorrichtungen zu isolieren. Wie gezeigt, ist eine weitere Wortleitung 120' über dem Graben 108 gebildet und davon durch den STI-Graben 180 isoliert. Die Wortleitung 120', welche über dem STI-Graben 180 verläuft, ist eine vorbeilaufende Wortleitung. Eine derartige Konfiguration bezeichnet man als eine gefaltete Bitleitungs-Architektur.

Der übliche Grabenkondensator nach Fig. 5 enthält ein Speicherdielektrikum 164, welches stufenförmig über dem Kragen 168 gebildet ist, was die Notwendigkeit der Entfernung des oberen Bereichs der Speicherdielektrikumschicht eliminiert. Dies vermeidet die Bildung von Nadellöchern am Übergang des Kragens und des oberen Randes der Speicherdielektrikumschicht. Zusätzlicherweise hat der untere Bereich des Grabens eine Breite bzw. einen Durchmesser W₂, der zumindest gleich groß ist wie die Breite bzw. der Durchmesser W₁ des oberen Bereichs. Demgemäß lassen sich reduzierte Leckströme und eine erhöhte Kapazität erzielen.

Ohne Beschränkung der Allgemeinheit ist die DRAM-Speicher-zelle 100 nach Fig. 5 eine MINT-Speicherzelle (MINT = merged isolation node trench) mit einer vergrabenen Brücke 162. Andere Zellkonfigurationen, wie z.B. diejenigen, die eine an der Oberfläche liegende Brücke verwenden, sind ebenfalls verwendbar. Die typischen Dimensionen eines Grabens 108, welcher beispielsweise in einem 256 Mb-DRAM-Chip unter Verwendung von 0,25 µm-Designregeln implementiert ist, betragen etwa 7-8 µm Tiefe, und zwar mit einer Grabenöffnung von etwa 0,25 µm mal 0,50 µm.

Wie in Fig. 5 gezeigt, ist der Grabenkondensator 160 im Substrat 101 gebildet. Das Substrat ist beispielsweise mit Dotierstoffen eines ersten Leitungstyps leicht dotiert. Bei diesem Beispiel ist das Substrat 101 leicht mit p-Typ-Dotierstoffen (p⁻), wie z.B. B, dotiert. Die Verwendung eines stark dotierten p-Typ-Substrats (p⁺) ist ebenfalls möglich. Beispielsweise können epitaktisch hergestellte p⁺/p⁻Substrate verwendet werden. Solche Substrate haben eine Dotierstoffkonzentration von etwa 10¹⁹ cm⁻³ mit einer p⁻-Epitaxieschicht von typischerweise 2-3 µm Dicke. Die Konzentration von B beträgt etwa 1,5 x 10¹⁶ cm⁻³. Eine (nicht gezeigte) p-Typ-Wanne ist zur Isolierung der Matrixvorrichtungen vorgesehen. Die Dotierungskonzentration der p-Wannen beträgt etwa 5 x 10¹⁷ bis 8 x 10¹⁷ cm⁻³.

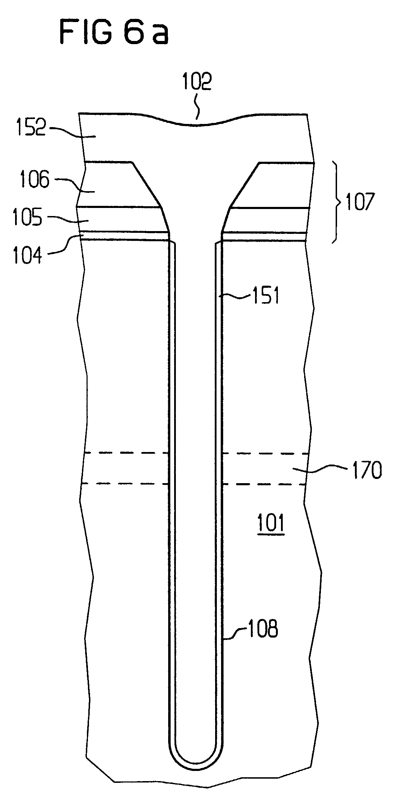

Fig. 6a-g zeigen Verfahrensschritte eines bekannten Verfahrens zur Herstellung der üblichen DRAM-Speicherzelle nach Fig. 5.

Mit Bezug auf Fig. 6a wird das Substrat 101 bereitgestellt, auf dem die DRAM-Speicherzelle herzustellen ist. Die Hauptoberfläche des Substrats 101 ist nicht kritisch, und eine beliebige geeignete Orientierung, wie z.B. (100), (110) oder (111), ist verwendbar. Bei dem vorliegenden Beispiel ist das Substrat 101 leicht dotiert mit p-Typ-Dotierstoffen (p⁻), wie z.B. B. Die Konzentration des B beträgt etwa 1 - 2 x 10¹⁶ cm⁻³.

Das Substrat 101 enthält die n-dotierte vergrabene Wanne 170. Die vergrabene Wanne 170 weist P oder As als Dotierstoff auf. Bei dem vorliegenden Beispiel wird eine Maske strukturiert, um die vergrabenen Wannenbereiche zu definieren. n-Typ-Dotierstoffe werden dann in die vergrabenen Wannenbereiche des Substrats 101 implantiert. Die vergrabene Wanne 170 dient zur Isolation der p-Wanne vom Substrat 101 und bildet ebenfalls eine leitende Brücke zwischen den vergrabenen Platten 165 der Kondensatoren. Die Konzentration und Energie der Implantation betragen etwa > 1 x 10¹³ cm⁻² bei etwa 1,5 MeV. Alternativermaßen wird die vergrabene Wanne 170 durch Implantieren und darauffolgendes Aufwachsenlassen einer Epitaxie-Siliziumschicht oberhalb der Substratoberfläche gebildet. Diese Technik ist im US-Patent Nr. 5,250,829 von Bronner et al. beschrieben.

Der Unterbaustapel 107 wird auf der Oberfläche des Substrats 101 gebildet. Der Unterbaustapel 107 umfaßt beispielsweise die Unterbau-Oxidschicht 104 und die Unterbau-Stoppschicht 105. Die Unterbau-Stoppschicht 105, welche als Politur oder Ätzstopp für folgende Prozesse gilt, weist beispielsweise Nitrid auf. Oberhalb der Unterbau-Stopp-schicht 105 ist die Hartmaskenschicht 106 vorgesehen. Diese Hartmaskenschicht 106 umfaßt TEOS. Andere Materialien, wie z.B. BSG, sind ebenfalls als Hartmaskenschicht verwendbar. Zusätzlicherweise kann eine Antireflexionsbeschichtung (ARC) verwendet werden, um die lithographische Auflösung zu verbessern.

Die Hartmaskenschicht 106 wird unter Verwendung üblicher fotolithographischer Techniken strukturiert, um den Bereich 102 zu definieren, in dem der Graben zu bilden ist. Diese Schritte enthalten die Abscheidung einer Fotolackschicht und das selektive Belichten derselben mit dem erwünschten Muster. Der Fotolack wird dann entwickelt und entweder die belichteten oder die unbelichteten Bereiche werden entfernt, und zwar abhängig davon, ob ein Positivlack oder ein Negativlack verwendet wird. Die belichteten Bereiche des Unterbaustapels 107 werden dann bis zur Oberfläche des Substrats 101 geätzt. Ein reaktiver Ionenätzschritt (RIE) bildet dann den tiefen Graben 108.

Eine Polysilizium-Halbleiterschicht 152 wird dann über dem Wafer abgeschieden, um den Graben 108 zu füllen. Amorphes Silizium ist ebenfalls verwendbar. Weitere Materialtypen, welche eine Temperaturstabilität bis zu 1050 bis 1100°C aufweisen und selektiv gegenüber Nitrid oder Oxid entfernbar sind, sind ebenfalls verwendbar. Das Polysilizium 152 wird als Polysilizium-Opferschicht bezeichnet, da es später entfernt wird. Typischerweise wird ein natürliches Oxid 151 gebildet, welches die Grabenseitenwände auskleidet, bevor der Graben mit dem Polysilizium 152 gefüllt wird. Die Oxidschicht 151 ist typischerweise etwa 0,3-5 nm dick.

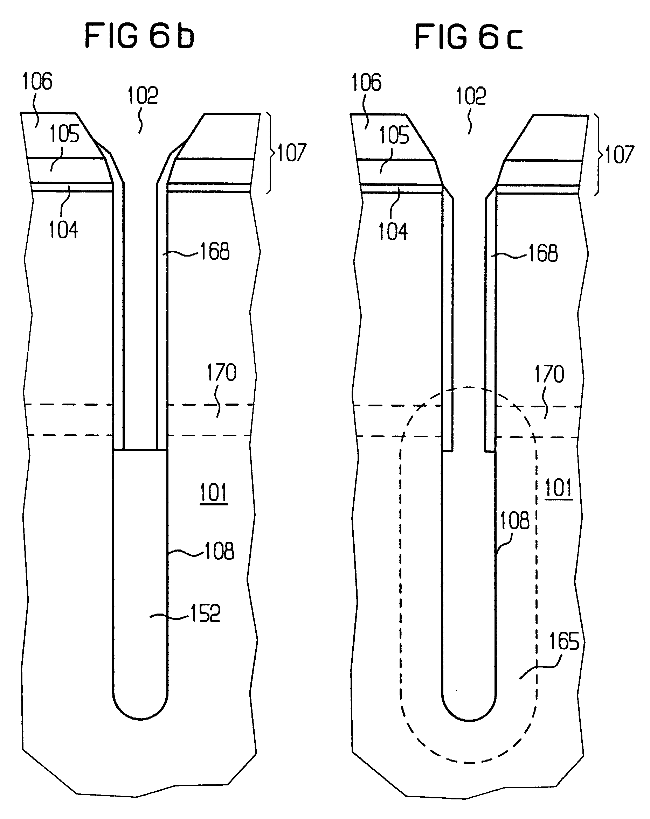

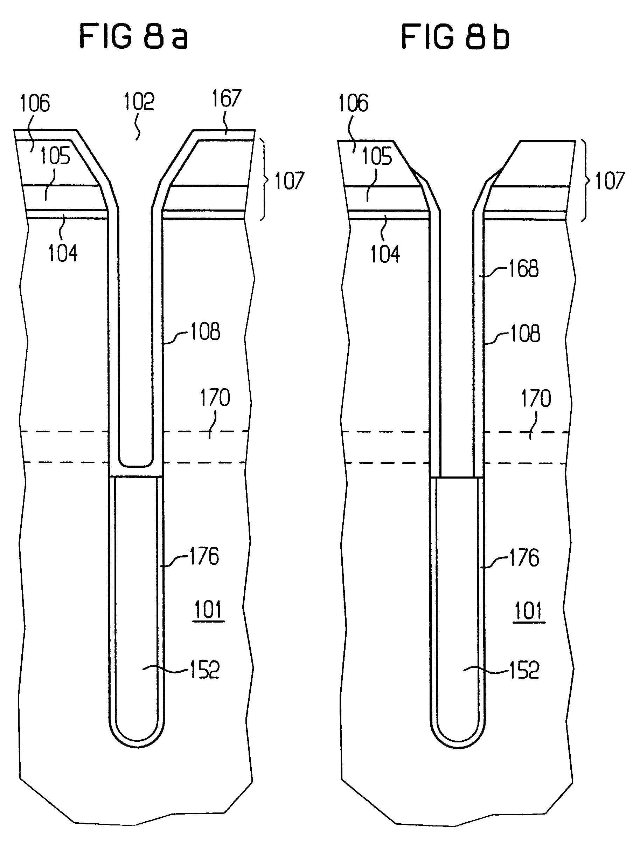

Wie in Fig. 6b gezeugt, wird das Polysilizium 152 dann bis zur Unterseite des zu bildenden Kragens entfernt. Das Entfernen des Polysiliziums 152 beinhaltet beispielsweise das Planarisieren mittels chemisch-mechanischen Polierens, ein chemisches Trockenätzen (CDE) oder ein reaktives Ionenätzen zum Bilden einer koplanaren Oberfläche mit der Oberseite des Polysiliziums in dem Graben 108 und an der Oberseite des Unterbaustapels 107. Ein reaktives Ionenätzen wird dann durchgeführt, um das Polysilizium 152 in dem Graben 108 einzusenken. Die Verwendung einer chemischen Trockenätzung zum Absenken des Polysiliziums 152 im Graben 108 ist ebenfalls möglich. Vorzugsweise jedoch wird das Polysilizium 152 planarisiert und durch ein CDE oder RIE in einem einzelnen Schritt eingesenkt, typischerweise um 0,5 - 2 µm von der Substratoberfläche.

Eine dielektrische Schicht wird dann über dem Wafer abgeschieden, welche den Unterbaustapel 107 und die Grabenseitenwände bedeckt. Die dielektrische Schicht wird zur Bildung des Kragens 168 verwendet. Die dielektrische Schicht ist beispielsweise aus Oxid. Bei diesem Beispiel wird die dielektrische Schicht durch Aufwachsen einer Schicht aus thermischem Oxid und darauffolgendes Abscheiden einer Oxidschicht durch chemische Dampfphasenabscheidung (CVD), wie z.B. plasmaunterstützte CVD (PECVD) oder Niederdruck-CVD (LPCVD), unter Verwendung von TEOS gebildet. Das CVD-Oxid kann durch einen Temperschritt verdichtet werden. Die Oxidschicht ist hinreichend dick, um einen vertikalen Leckstrom zu vermeiden, nämlich 10-50 nm. Alternativermaßen kann die dielektrische Schicht eine Schicht aus thermischem Oxid aufweisen.

Bei einem anderen Beispiel wird die dielektrische Schicht aus CVD-Oxid gebildet. Nach der Bildung des CVD-Oxids kann ein Temperschritt zur Verdichtung des Oxids durchgeführt werden. Der Temperschritt wird beispielsweise in Ar, N₂, O₂, H₂O, N₂O, NO oder NH₃-Atmosphäre durchgeführt. Eine oxidierende Atmosphäre, wie z.B. O₂ oder H₂O kann zur Bildung einer thermischen Oxidschicht unter dem CVD-Oxid verwendet werden. Sauerstoff aus der Atmosphäre diffundiert dann durch das CVD-Oxid zum Bilden einer thermischen Oxidschicht auf der Substratoberfläche. Dies ermöglicht vorteilhafterweise die Bildung eines thermischen Oxids, falls erwünscht, ohne das Bedürfnis eines thermischen Oxidationsschritts vor der Abscheidung des CVD-Oxids. Typischerweise wird der Temperschritt bei einer Temperatur von etwa 1000-1100°C und etwa 0,5-3 Stunden lang durchgeführt.

Weiter mit Bezug auf Fig. 6b wird die dielektrische Schicht beispielsweise durch reaktives Ionenätzen geätzt, um den Kragen 168 zu bilden. Die chemischen Mittel für das reaktive Ionenätzen werden derart gewählt, daß das Oxid selektiv gegenüber dem Polysilizium 152 und dem Nitrid 106 geätzt wird. Das reaktive Ionenätzen entfernt die dielektrische Schicht von der Oberfläche des Unterbaustapels und dem Boden der Öffnung. Die dielektrische Schicht bleibt auf der Siliziumseitenwand, um den Kragen 168 zu bilden. Wie in Fig. 6b abgebildet, ist der obere Bereich des Kragens 168 leicht erodiert und bildet einen abgeschrägten oberen Abschnitt.

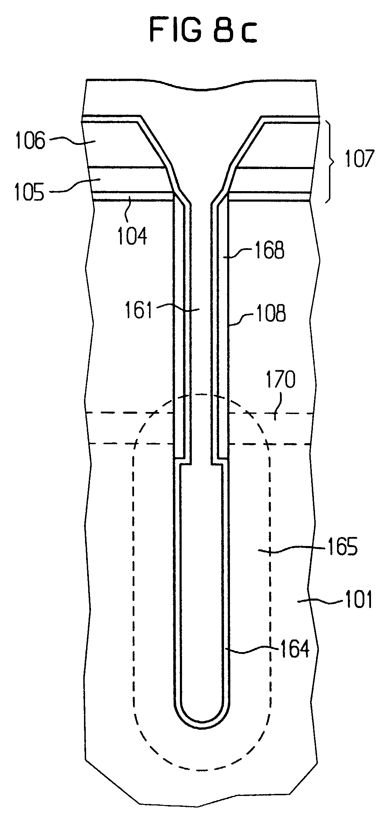

Mit Bezug auf Fig. 6c wird die Polysilizium-Opferschicht 152 von der Unterseite des Grabens 108 entfernt. Das Entfernen der Polysilizium-Opferschicht 152 wird vorzugsweise durch CDE erreicht. Die dünne natürliche Oxidschicht 151 liegt dann typischerweise auf den freigelegten Grabenseitenwänden vor. Diese dünne natürliche Oxidschicht 151 kann ausreichen, um als CDE-Ätzstopp zu dienen. Ein CDE-Ätz-schritt, beispielsweise unter Verwendung von NF₃ + Cl₂ als Chemikalien kann Silizium oder Polysilizium mit relativ hoher Selektivität gegenüber Oxid ätzen, was eine Entfernung des Polysiliziums unter Verwendung der dünnen natürlichen Oxidschicht 151 als Ätzstopp ermöglicht. Beispielsweise wurde eine Selektivität von etwa 4000:1 für das Entfernen des Polysiliziums von dem Graben 108 unter Verwendung des natürlichen Oxids 151 als Ätzstoppschicht ermittelt.

Bei einem anderen Beispiel wird ein CDE-Schritt mit hohem Cl₂-Gehalt verwendet, um die Selektivität der Silizium- bzw. Polysiliziumätzung gegenüber dem Oxid zu erhöhen. Eine Strömungsrate von etwa 12 sccm resultiert in einer effektiven Oxidätzrate von null, während die Polysilizium-Ätzrate in der Größenordnung von etwa 2 µm/min liegt. Dies ermöglicht, daß die natürliche Oxidschicht 151 als effizienter Ätzstopp für die Entfernung der Opfer-Polysiliziumschicht dient. Typischerweise beträgt die Dicke des natürlichen Oxids 151 etwa 0,5 bis 1 nm.

Alternativermaßen kann eine Naßätzung, beispielsweise unter Verwendung von KOH oder HF:HNO₃:CH₃COOH ebenfalls beim Entfernen des Polysiliziums verwendet werden. Die Verwendung von KOH jedoch kann zu einer K-Kontamination auf der Grabenseitenwand führen, was einen zusätzlichen Reinigungsschritt erfordern kann. Eine reaktive Ionenätzung ist ebenfalls möglich beim Entfernen des Polysiliziums, da sie anisotrop wirkt. Geeignete Chemikalien für die reaktive Ionenätzung für die Beseitigung des Polysiliziums enthalten SF₆/NF₃/HBr. Andere geeignete Chemikalien, welche Polysilizium selektiv gegenüber Oxid oder Nitrid ätzen, sind beispielsweise NF₃/HBr oder CF₄/O₂ oder CF₄/O₂/Cl₂.

Die Selektivität der reaktiven Ionenätzung hinsichtlich Poly gegenüber Oxid oder Nitrid beträgt etwa weniger als 100:1 auf planaren Oberflächen, aber steigt auf mehr als etwa 2000:1 auf vertikalen Oberflächen, und zwar aufgrund der vorzugsweise vertikalen Richtung der Bewegung der Ionen während der reaktiven Ionenätzung. Aufgrund der hohen Selektivität des Polysiliziums gegenüber Oxid oder Nitrid auf den vertikalen Oberflächen wird nur der obere Bereich des Kragens 168 erodiert. Jedoch ist dies kein Problem, da der Kragen 168 nicht unterhalb der Oberfläche des Substrats erodiert wird.

Nach Entfernung des Polysiliziums wird die vergrabene Platte 165 mit n-Typ-Dotierstoffen, wie z.B. As oder P, optionell als die zweite Kondensatorelektrode gebildet. Der Kragen 168 dient als Isolationsmaske, die ermöglicht, daß nur der Bereich unterhalb des Kragens 168 dotiert wird. Die Konzentration der Dotierstoffe beträgt etwa 1 x 10¹⁹- 10²⁰ cm⁻³. Zur Bildung der vergrabenen Platte 165 kann eine Gasphasendotierung unter Verwendung von PH₃ oder AsH₃, eine Plasmadotierung oder eine Plasmaimmersions-Ionenimplanta-tion (PIII) verwendet werden. Solche Techniken sind beispielsweise beschrieben in Ransom et al., J. Electrochemical. Soc. Band 141, Nr. 5 (1994), S. 1378 ff.; US-Patent Nr. 5,344,381 und US-Patent Nr. 4,937,205.

Eine Ionenimplantation unter Verwendung des Kragens 168 als Isolationsmaske ist ebenfalls möglich. Alternativermaßen kann die vergrabene Platte 165 unter Verwendung eines dotierten Silikatglases, wie z.B. ASG, als Dotierstoffquelle gebildet werden. Die Verwendung von dotiertem Silikatglas als Dotierstoffquelle ist beispielsweise beschrieben in Becker et al., J. Electrochemical. Soc., Band 136 (1989), S. 3033 ff. Wenn dotiertes Silikatglas verwendet wird, wird die Schicht nach der Bildung der vergrabenen Platte entfernt.

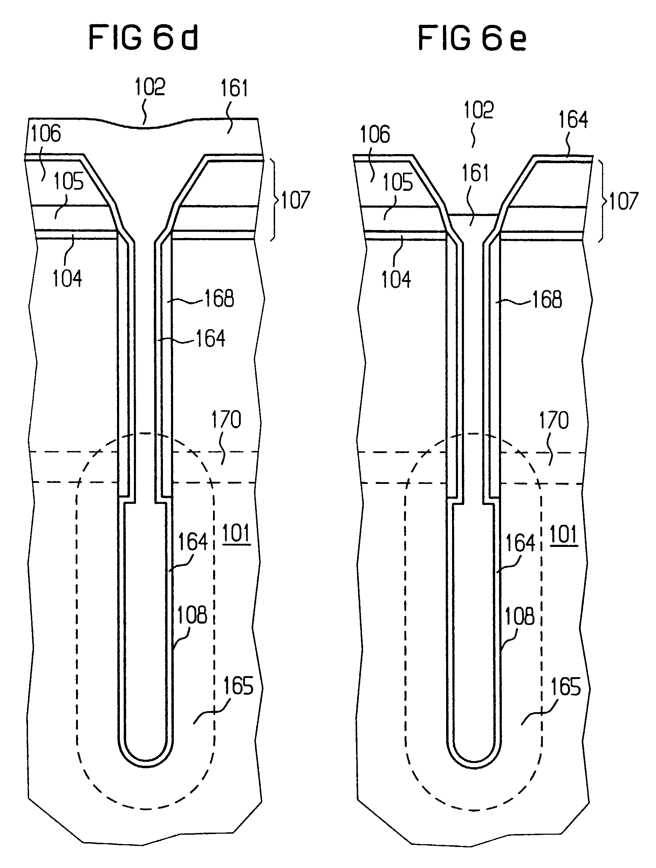

Mit Bezug auf Fig. 6d wird eine Speicherdielektrikumschicht 164 auf dem Wafer abgeschieden, welche die Oberfläche des Unterbaustapels 107 und das Innere des Grabens 108 bedeckt. Die Speicherdielektrikumschicht 164 dient als Speicherdielektrikum zum Separieren der Kondensatorplatten. Bei einem Beispiel umfaßt die dielektrische Schicht einen NO-Film-Stapel. Der NO-Film-Stapel wird durch Abscheiden einer Nitridschicht gebildet, welche dann reoxidiert wird. Die Nitridschicht wird beispielsweise durch thermische Nitrierung und CVD-Nitrid mit einer Dicke von etwa 5 nm ausgebildet. Die Nitridschicht wird beispielsweise bei einer Temperatur von etwa 900°C reoxidiert. Die Reoxidation der Nitridschicht erhöht die Dicke der Nitridschicht marginal. Weitere Typen von dielektrischen Filmstapeln, wie z.B. Oxid-Nitrid-Oxid (ONO) oder Oxid-Nitrid-Oxid-Nitrid (ONON), sind ebenfalls nützlich. Ebenfalls ist die Verwendung eines dünnen Oxids, Nitrids oder nitrierten Oxidfilms möglich.

Eine weitere Polysiliziumschicht 161 wird auf der Oberfläche des Wafers zum Füllen des Grabens 108 und zum Bedecken des Unterbaustapels 107 abgeschieden, und zwar beispielsweise durch CVD oder andere bekannte Techniken. Wie gezeigt, ist die Polysiliziumschicht 161 konform und dotiert mit n-Typ-Dotierstoffen, wie z.B. P und As. Bei einem Beispiel ist die Polysiliziumschicht 161 mit As dotiert. Die Konzentration von As beträgt etwa 1 x 10¹⁹- 1 x 10²⁰ cm⁻³. Das dotierte Polysilizium 161 dient als Kondensatorelektrode. Alternativermaßen kann die Schicht aus amorphem Silizium bestehen. Dieses Material kann entweder in situ oder sequentiell dotiert werden.

Mit Bezug auf Fig. 6e wird die Polysiliziumschicht 161 beispielsweise durch einen CDE-Schritt oder durch einen RIE-Schritt unter Verwendung geeigneter Chemikalien, wie z.B. NF₃/Cl₂ oder NF₃/HBr oder SF₆ abgesenkt. Bei einem anderen Beispiel wird das Polysilizium 161 auf etwa den Pegel des Unterbau-Nitrids 106 abgesenkt. Dies schützt vorteilhafterweise das Unterbauoxid 105 während der folgenden Naßätzprozesse. Falls die Unterätzung kein Problem darstellt, kann das Polysilizium bis zur Tiefe der vergrabenen Brücke eingesenkt werden.

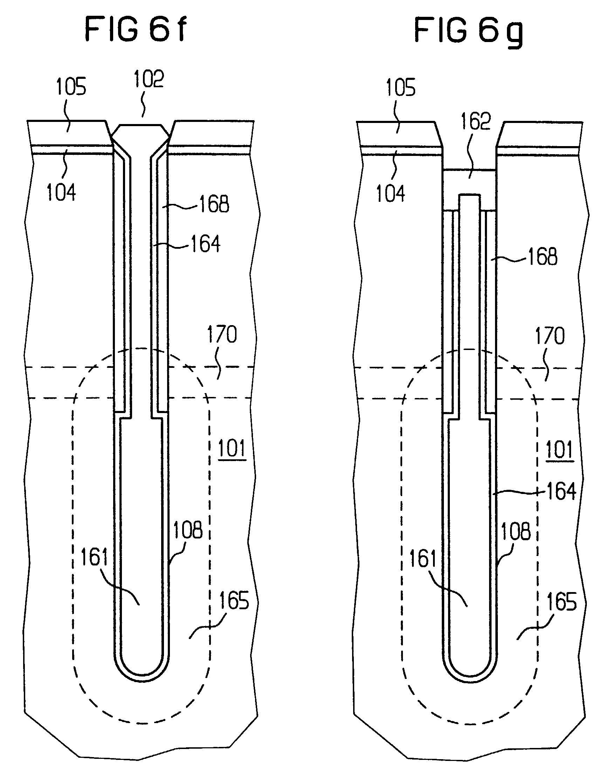

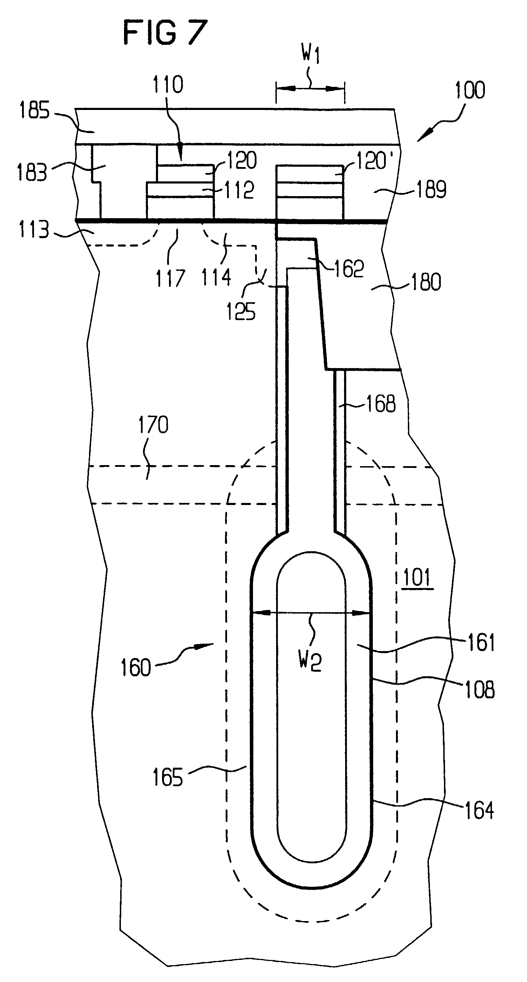

Gemäß Fig. 6f wird die restliche Speicherdielektrikumsschicht 164 oberhalb des Polysiliziums 161 mit einer Naßätzung entfernt, und zwar beispielsweise mit DHF und HF/Glyzerol. Die Hartmaskenschicht 106 wird dann ebenfalls naßchemisch entfernt, und zwar mit BHF. Auch ist die Durchführung eines CDE-Schrittes dazu möglich. Die Hartmaskenschicht kann auch füher im Prozeßablauf entfernt werden, wie z.B. nach der Bildung des tiefen Grabens 108. Wie gezeigt, sind der Kragen 168 und die dielektrische Schicht 164 im Graben 108 ebenfalls leicht eingesenkt.

Wie in Fig. 6g gezeigt, wird dann die vergrabene Brücke 162 gebildet. Die Bildung der vergrabenen Brücke 162 wird beispielsweise durch eine Ätzung zum Einsenken des dotierten Polysiliziums 161 in dem Graben erreicht. Typischerweise wird hierzu eine reaktive Ionenätzung verwendet. Der nicht-aktive Bereich der Zelle wird dann durch eine übliche fotolithographische Technik definiert und dann anisotrop geätzt, und zwar zweckmäßigerweise durch reaktives Ionenätzen. Der nicht-aktive Bereich ist der Bereich, in dem der STI-Graben 180 zu bilden ist.

Wie mit erneutem Bezug auf Fig. 5 gezeigt, überlappt der STI-Graben 180 einen Teil des Grabens, um so einen Teil der Brükke 162 abzuschneiden. In einem folgenden Temperschritt diffundieren Dotierstoffe von dem dotierten Polysilizium 161 nach oben und nach außen durch die Brücke 162 zum Bilden des Diffusionsbereichs 125. Die Tiefe des STI-Grabens beträgt etwa 0,25 µm. Typischerweise wird der nicht-aktive Bereich unterhalb der Oberseite des Oxids des Kragens 168 geätzt. Bei einem Beispiel wird der nicht-aktive Bereich etwa 0,25 µm unterhalb der Substratoberfläche geätzt.

Nachdem der nicht-aktive Bereich geätzt ist, werden die Fotolack- und ARC-Schichten entfernt. Um zu gewährleisten, daß keine Fotolack- oder ARC-Rückstände zurückbleiben, können Reinigungsschritte verwendet werden. Um zu verhindern, daß Sauerstoff in die Silizium- und Polysiliziumseitenwände diffundiert, ist eine (nicht gezeigte) optionale Verkleidung vorgesehen, um den nicht-aktiven Bereich zu schützen. Die Verkleidung umfaßt beispielsweise Nitrid. Typischerweise wird ein Passivierungsoxid thermisch auf dem freiliegenden Silizium vor der Bildung der Nitridauskleidung aufgewachsen. Die Nitridauskleidung wird beispielsweise durch chemische Niederdruck-Dampfabscheidung (LPCVD) gebildet.

Ein dielektrisches Material wird auf der Oberfläche des Substrats gebildet. Das dielektrische Material weist beispielsweise SiO₂ auf. Bei einem weiteren Beispiel ist das dielektrische Material TEOS. Ein Hochdichteplasma(HDP)-Oxid oder ein anderes Isolationsmaterial kann verwendet werden. Die Dicke der dielektrischen Schicht reicht aus zum Füllen des nicht-aktiven Bereichs. Da die dielektrische Schicht typischerweise konform ist, werden Planarisierungsverfahren, wie z.B. chemisch-mechanisches Polieren, angewendet. Solche Verfahren sind beispielsweise beschrieben in Nesbit et al., A 0,6 µm² 256Mb Trench DRAM Cell With Self-Aligned Buried Strap (BEST), IEDM 93-627. Die Oberfläche des Substrats 101 wird dann derart poliert, daß die STI-Gräben 180 und die Nitridschicht im wesentlichen planar sind.

Die Unterbau-Stoppschicht 105 wird dann beispielsweise durch eine naßchemische Ätzung entfernt. Die naßchemische Ätzung ist selektiv gegenüber Oxid. Das Unterbauoxid 104 wird ebenfalls an diesem Punkt durch eine naßchemische Ätzung entfernt, welche selektiv gegenüber Silizium ist. Nach Entfernung des Unterbauoxids 104 wird eine Oxidschicht auf der Oberfläche des Wafers gebildet. Diese Oxidschicht, welche als Gate-Opferschicht bezeichnet wird, dient als Streuoxid für folgende Implantationen.

Zur Definition eines Bereichs für eine p-Typ-Wanne für den n-Kanal-Transistor 110 der DRAM-Speicherzelle wird eine Fotolackschicht auf der Oberseite der Oxidschicht abgeschieden und geeignet strukturiert, um den p-Wannenbereich freizulegen. Wie gezeigt, werden p-Typ-Dotierstoffe, wie z.B. Bor (B) in den Wannenbereich implantiert. Die Dotierstoffe werden hinreichend tief implantiert, um einen Punchthrough zu verhindern und den Schichtwiderstand zu reduzieren. Das Dotierstoffprofil ist derart bemessen, daß die erwünschten elektrischen Charakteristika erhalten werden, z.B. eine erwünschte Gate-Schwellspannung (Vₜₕ).

Zusätzlicherweise werden ebenfalls p-Typ-Wannen für die n-Kanal-Versorgungsschaltungsanordnung gebildet. Für komplementäre Wannen in komplementären Metalloxid-Silizium-vorrichtungen (CMOS) werden n-Wannen gebildet. Die Bildung von n-Typ-Wannen erfordert zusätzlich fotolithographische Schritte und Implantationsschritte zum Definieren und Bilden der n-Typ-Wannen. Wie bei den p-Typ-Wannen sind die Profile der n-Typ-Wannen auf das Erreichen der erwünschten elektrischen Charakteristika zugeschnitten. Nach Bildung der Wannen wird die Gate-Opferschicht entfernt.

Die verschiedenen Schichten zum Bilden des Gates 112 des Transistors 110 werden dann hergestellt. Dies umfaßt das Bilden einer Gate-Oxidationsschicht, welche als Gate-Oxid dient, einer Polysiliziumschicht und einer Decknitridschicht. Typischerweise kann die Polysiliziumschicht eine Metallsilizidschicht, wie z.B. WSiₓ, enthalten, wobei das gebildete Polycide den Schichtwiderstand reduziert. Die verschiedenen Gate-Schichten werden dann strukturiert, um den Gate-Stapel 112 des Transistors 110 zu bilden. Die Seitenwand des Gatestapels wird dann z.B. durch thermische Oxidation isoliert.

Ein vorbeilaufender Gate-Stapel als Wortleitung 120' wird typischerweise über dem Graben gebildet und ist davon durch den STI-Graben 180 isoliert. Die Source/Drain-Diffusions-bereiche 413 und 414 werden durch Implantieren von n-Typ-Dotierstoffen, wie z.B. P oder As gebildet. Bei einem Beispiel wird P in die Source- und Drain-Bereiche 113, 114 implantiert. Die Dosis und die Energie werden derart ausgewählt, daß ein Dotierstoffprofil erzielt wird, welches die erwünschten Betriebscharakteristika gewährleistet. Zur Verbesserung der Diffusion und der Ausrichtung der Source und des Drain mit dem Gate können Nitridabstandshalter (nicht gezeigt) verwendet werden. Der Diffusionsbereich 114 ist mit dem Diffusionsbereich 125 verbunden, um so den Kondensatoranschluß zu bilden.

Die dielektrische Schicht 189 wird über der Waferoberfläche gebildet, und sie überdeckt die Gates 112 und die Substratoberfläche. Die dielektrische Schicht umfaßt beispielsweise BPSG. Weitere dielektrische Schichten, wie z.B. TEOS, sind ebenfalls nützlich. Wie gezeigt, wird eine randlose Kontaktöffnung 483 geätzt, um den Diffusionsbereich 413 zu freizulegen. Die Kontaktöffnung wird dann mit einem leitenden Material, wie z.B. n⁺-dotierten Polysilizium gefüllt, um darin einen Kontaktstöpsel zu bilden. Die Metallschicht 485, welche eine Bitleitung darstellt, wird über der dielektrischen Schicht gebildet, um einen Kontakt mit der Source über den Kontaktstöpsel zu bilden. So erhält man schließlich die in Fig. 5 gezeigte Struktur.

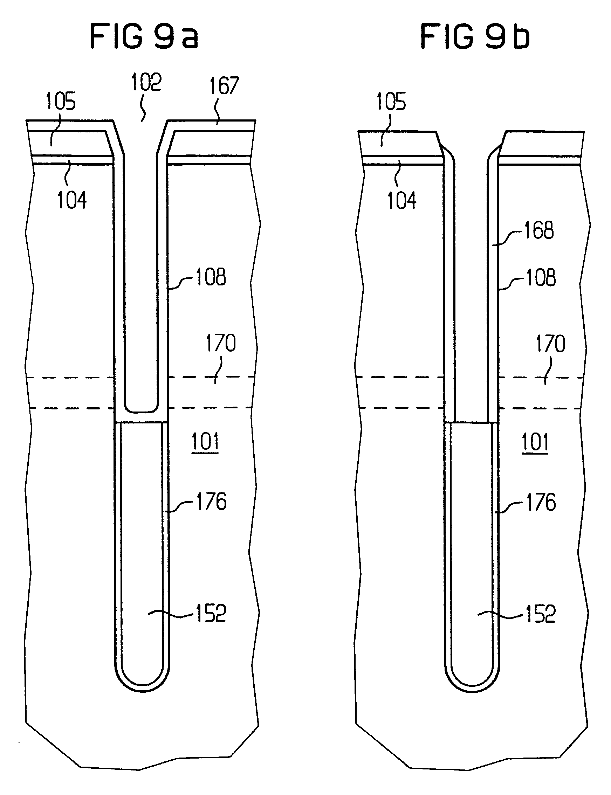

Fig. 7 zeigt ein weiteres Beispiel einer üblichen DRAM-Speicherzelle.

Wie dort gezeigt, ist die Breite W2 bzw. der Durchmesser des unteren Bereichs des Grabenkondensators 160 größer als die Breite W1 bzw. der Durchmesser des oberen Bereichs. Die Erhöhung von W1 erhöht die Kapazität des Kondensators. Zum Erzielen solch einer Struktur wird die in Fig. 6b beschriebene Polysilizium-Opferschicht 152 durch CDE beseitigt, beispielsweise mit NF₃/Cl₂. Weitere Chemikalien zum selektiven Ätzen von Silizium sind ebenfalls verwendbar. Zusätzlich ist eine reaktive Ionenätzung unter Verwendung von SF₆, NF₃/HBr oder eine Naßätzung unter Verwendung von KOH anwendbar. Der untere Teil des Grabens wird beispielsweise durch eine CDE-Ätzung aufgeweitet. Die Aufweitung des Grabens ist beispielsweise beschrieben in T. Ozaki et al., 0,228 µm² Trench Cell Technologies with Bottle-shaped Capacitor for 1 Gigabit DRAMs, IEDM 95, pp. 661 oder US-Patent Nr. 5,336,912 von S. Ohtsuki. Das Ätzmittel für die CDE-Ätzung ist derart ausgewählt, daß es ebenfalls des dünnen natürlichen Oxidfilm auf den Grabenseitenwänden entfernt. Dies kann durch Reduzieren der Strömungsrate von Cl₂ erzielt werden, um die Selektivität der Ätzung gegenüber dem Oxid zu erniedrigen, oder durch Änderung der Chemikalien.

Die Naßätzung oder die CDE ist so gesteuert, daß sie das Opfer-Polysilizium entfernt, während sie die Aufweitung derart begrenzt, daß sie sich nicht in benachbarte Gräben erstreckt oder diese kontaktiert. Die Aufweitung des unteren Bereichs des Grabens beträgt etwa 50% des minimalen Abstands zwischen benachbarten Gräben, und vorzugsweise weniger als 20-30% des minimalen Abstands zwischen benachbarten Gräben. Da der Abstand zwischen benachbarten Gräben typischerweise zur minimalen Dimension ist, sollte die Aufweitung auf weniger als 50% der minimalen Dimension begrenzt sein. Dies liefert beispielsweise einen Graben mit Flaschengestalt, dessen unterer Durchmesser weniger als die doppelte minimale Dimension beträgt. Vorzugsweise beträgt die Aufweitung des Grabens etwa 20-40% der minimalen Dimension.

Nach Entfernen des Opfer-Polysiliziums und der Ätzstoppschicht kann optionellerweise die vergrabene Platte 165 gebildet werden. Verschiedene Techniken zum Bilden der vergrabenen Platte, wie z.B. Gasphasendotierung mit AsH₃ oder PH₃ bei Temperaturen von etwa 1000-1100°C, Ionenimplantation von As oder P, Plasmadotierung oder Plasmaimmersions-Ionenimplantation sind ebenfalls möglich. Das dotierte Polysilizium wird dann abgeschieden, um die Kondensatorelektrode zu bilden. Das dotierte Polysilizium füllt den unteren Bereich des Grabens unter Bildung eines Hohlraums 172. Da der Hohlraum 172 in dem unteren Bereich des Grabens liegt, beeinflußt er die folgende Verarbeitung oder Funktionalität der Vorrichtung nicht. Weitere Techniken zum Erhöhen der Grabenkapazität, wie z.B. die Bildung von halbkugelartigen Siliziumkörnern (HSG) in dem Graben oder das Aufrauhen der Grabenseitenwände vor der Abscheidung des Speicherdielektrikums sind ebenfalls möglich.

Fig. 8a-c zeigen ein weiteres Beispiel eines bekannten Verfahrens zur Herstellung der DRAM-Speicherzelle nach Fig. 5.

Mit Bezug auf Fig. 8a wird das Substrat 101 bereitgestellt. Wie gezeigt, enthält das Substrat die vergrabene n-Typ-Wanne 170. Der Unterbaustapel 107, welcher die Unterbau-Oxidschicht 104, die Unterbau-Stoppschicht 105 und die Hartmaskenschicht 106 enthält, wird auf der Oberfläche des Substrats 101 gebildet. Der Unterbaustapel 107 wird derart strukturiert, daß er den Grabenbereich 102 definiert, und ein tiefer Graben 108 wird darin durch reaktives Ionenätzen gebildet.

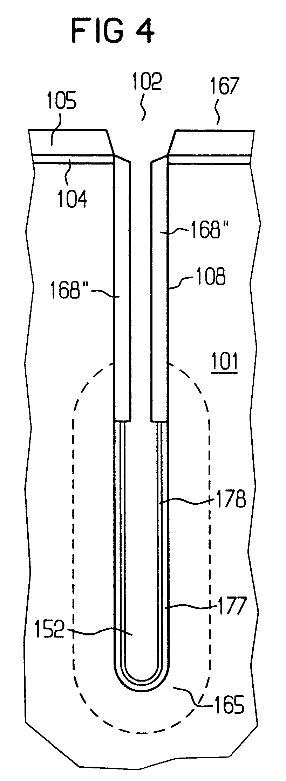

Nach Bildung des Grabens 108 wird eine Ätzstoppschicht 176 auf den Grabenseitenwänden abgeschieden. Die Ätzstoppschicht 176 ist besonders nützlich, falls die natürliche Oxidschicht 151 (vgl. Fig. 4a) auf den Grabenseitenwänden zu dünn ist (etwa < 1 nm), um als Ätzstopp hinreichend zu funktionieren. Die Ätzstoppschicht 176 bedeckt den Unterbaustapel 107 und kleidet die Grabenseitenwände aus. Bei einem weiteren Beispiel umfaßt die Ätzstoppschicht ein Material, welchem gegenüber Polysilizium selektiv entfernt werden kann. Die Dicke der Ätzstoppschicht 176 ist hinreichend, um zu gewährleisten, daß darauffolgend abgeschiedenes Polysilizium-Opfermaterial 152 von dem Graben 108 entfernt wird, ohne die Seitenwände aufzuweiten, um eine Deformierung des Grabens z.B. durch Unterätzungen unter dem Unterbauoxid zu vermeiden. Die tatsächliche Dicke, welche erforderlich ist, wird abhängig von den Verfahrensbedingungen der Ätzung, die zum Entfernen des Opfer-Polysiliziums 152 verwendet wird, optimiert. Typischerweise beträgt die Dicke der Schicht etwa 1-20 nm, und vorzugsweise etwa 1-5 nm.

Bei einem weiteren Beispiel umfaßt die Ätzstoppschicht ein dielektrisches Material, wie z.B. Oxid, Nitrid oder Oxinitrid, gebildet durch verschiedene Techniken, wie z.B. thermisches Wachstum oder CVD. Vorzugsweise weist die Ätzstoppschicht Oxid auf. Die Verwendung von Oxid vermeidet vorteilhafterweise die Notwendigkeit der Beseitigung des oberen Bereichs vor der Bildung des Kragens oder die Entfernung des unteren Bereichs nach dem Entfernen des Opfer-Polysiliziums.

Die Opfer-Polysiliziumschicht 152 wird über dem Wafer zum Füllen des Grabens 108 abgeschieden. Das Opfer-Polysilizium 152 wird dann eingesenkt, um es von dem oberen Bereich des Grabens zu entfernen, und zwar wird es etwa bis zur Unterseite des zu bildenden Kragens 168 eingesenkt. Optionellerweise wird der freigelegte Bereich der Ätzstoppschicht in dem oberen Bereich des Grabens beispielsweise unter Verwendung einer Naßätzung mit DHF-Chemikalien entfernt. Eine Kragenschicht 167 wird dann gebildet, welche den oberen Bereich des Grabenseitenwände und die Oberseite des Opfer-Polysiliziums bedeckt. Die dielektrische Schicht, welche als das Kragenoxid dient, umfaßt typischerweise ein dünnes thermisches Oxid unter einem CVD-Oxid. Optionellerweise kann eine Temperung durchgeführt werden, um die Kragenschicht zu verdichten. Alternativermaßen wird das Kragen-oxid durch Abscheiden eines CVD-Oxid und Verdichten des selben in einer oxidierenden Umgebung gebildet. Dies erleichtert die Bildung eines thermischen Oxids an der Grenzfläche Graben/CVD-Oxid, was die Zuverlässigkeit des Kragens 168 erhöht. Die Bildung eines rein thermisch aufgewachsenen Kragenoxids (z.B. 30 - 40 nm) ist ebenfalls möglich, involviert aber eine stärkere Versetzungsbildungstendenz.

Mit Bezug auf Fig. 8b wird die Kragenschicht 168 durch reaktives Ionenätzen zum Bilden des Kragens 168 geätzt. Das Opfer-Polysilizium 152 wird dann mit reaktivem Ionenätzen oder CDE entfernt. Eine Naßätzung ist ebenfalls nützlich beim Entfernen des Opfermaterials. Die Oxid-Ätzstoppschicht verhindert, daß die Ätze die Grabenseitenwände aufweitet, während das Opfer-Polysilizium entfernt wird.

Mit Bezug auf Fig. 8c wird dann die Oxid-Ätzstoppschicht 176 entfernt. Die vergrabene Platte 165 wird dann unter Verwendung zuvor erörterter Techniken gebildet. Eine dielektrische Schicht 164 wird dann über dem Wafer derart abgeschieden, daß sie den Kragen 168 und die Grabenseitenwände in dem unteren Bereich des Grabens überdeckt. Die dielektrische Schicht dient als das Speicherdielektrikum des Grabenkondensators. Eine dotierte Polysiliziumschicht 161 wird dann zum Füllen des Grabens abgeschieden. Der Prozeß zum Bilden des Grabenkondensators und der Speicherzelle läuft dann weiter, wie mit Bezug auf die Fig. 6d-g erörtert.

Fig. 9a-c zeigen ein weiteres Beispiel eines üblichen Verfahrens zur Herstellung der DRAM-Speicherzelle nach Fig. 5.

Wie in Fig. 9a gezeigt, ist der Unterbaustapel 107 mit der Unterbau-Oxidschicht 104, der Unterbau-Stoppschicht 105 und der Hartmaskierungsschicht (nicht gezeigt) auf der Oberfläche des Substrats 101 gebildet. Der Unterbaustapel 107 wird strukturiert, um einen Grabenbereich 102 zu bilden. Eine reaktive Ionenätzung wird zum Bilden des tiefen Grabens 108 in dem Grabenbereich 102 durchgeführt. Eine vergrabene n-Typ-Wanne 170 wird ebenfalls in dem Substrat 101 gebildet.

Die Hartmaskenschicht 106 wird nach der Bildung des Grabens abgenommen, um die Unterbau-Stoppschicht 105 und die Unterbau-Oxidschicht 104 auf der Substratoberfläche zurückzulassen. Eine Ätzstoppschicht 176 wird derart gebildet, daß sie als Ätzstopp für die Beseitigung des Opfer-Polysiliziums 152 von dem Graben dient. Nach der Bildung der Ätzstoppschicht wird das Opfer-Polysilizium 152 abgeschieden, um den Graben 108 zu füllen. Das Opfer-Polysilizium 152 wird auf eine erwünschte Tiefe eingesenkt, die etwa an der Unterseite des Kragens 168 liegt. Der freigelegte Bereich der Ätzstoppschicht 176 kann beispielsweise durch eine nasse DHF-Ätzung oder durch eine CDE-Ätzung erzeugt werden. Die Entfernung des freigelegten Bereichs der Ätzstoppschicht 176 entfernt ebenfalls die RIE-Beschädigung und Kontaminierung des Grabens, was die Zuverlässigkeit des darauffolgend gebildeten Kragens 168 verbessert. Eine dielektrische Schicht 167 wird dann so abgeschieden, daß sie die Oberfläche und die Seitenwände des Grabens bedeckt. Die dielektrische Schicht wird zum Bilden des Kragens 168 verwendet. Eine Temperung wird durchgeführt, um die dielektrische Schicht 167 zu verdichten. Alternativermaßen wird ein CVD-Oxid abgeschieden und in einer oxidierenden Atmosphäre getempert, um das CVD-Oxid zu verdichten und um ein thermisches Oxid unter dem CVD-Oxid zu bilden, und zwar in einem einzelnen thermischen Verarbeitungsschritt.

Mit Bezug auf Fig. 9b wird ein reaktives Ionenätzen zum Bilden des Kragens 168 durchgeführt. Nach dem reaktiven Ionenätzen werden das Opfer-Polysilizium 152 und die Ätzstoppschicht 176 entfernt.

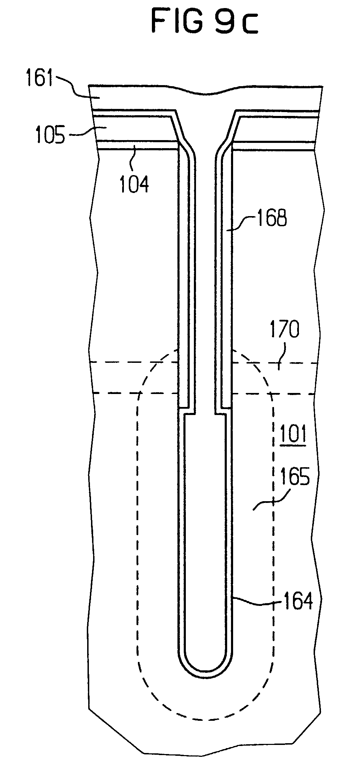

Mit Bezug auf Fig. 9c wird die vergrabene Platte 165 unter Verwendung der bereits beschriebenen Techniken gebildet. Das Speicherdielektrikum 164 wird danach gebildet. n-dotiertes Polysilizium 161 füllt dann den Graben.

Dann wird zum Erreichen des in Fig. 6g gezeigten Prozeßstadiums das Füll-Polysilizium 161 eingesenkt, um die vergrabene Brücke 162 zu definieren. Das Speicherdielektrikum 164 und das Kragenoxid 168 werden entfernt, und das Polysilizium bzw. das amorphe Silizium für die vergrabene Brücke 162 wird abgeschieden, planarisiert und eingesenkt. An diesem Punkt fährt das Verfahren fort, wie in bezug auf Fig. 6g bereits beschrieben.

Im Zusammenhang mit diesem Beispiel sei erwähnt, daß bei entsprechend dünner Ätzstoppschicht 176, d.h. bei einer Dicke, durch die Dotiermittel, wie As und P, diffundieren können, die vergrabene Platte 165 durch Ausdiffusion des Opfer-Polysiliziums 152 hergestellt werden kann, welches zu diesem Zweck dotiert sein muß (z.B. mit As oder P).

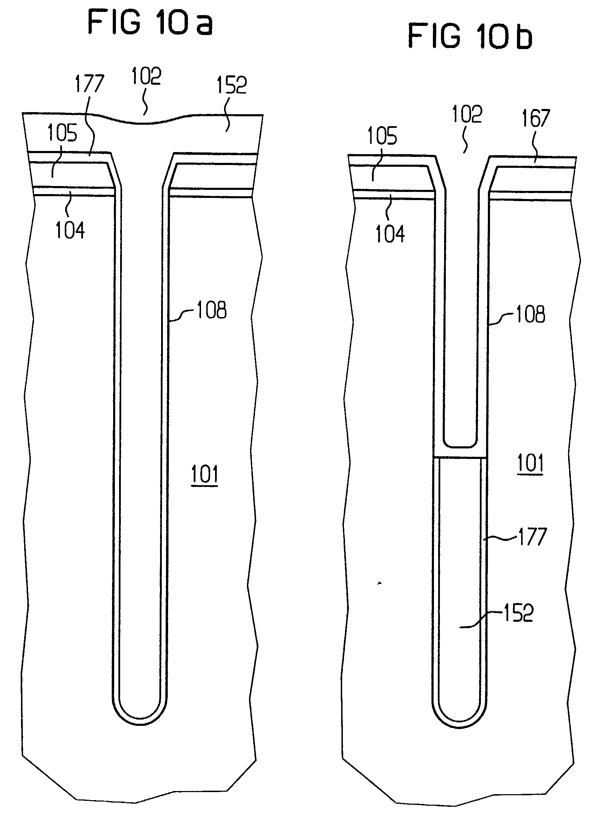

Fig. 10a-e zeigen ein weiteres Beispiel eines bekannten Verfahrens zur Herstellung der DRAM-Speicherzelle nach Fig. 5.

Bei diesem Beispiel wird anstelle der undotierten Ätzstoppschicht 176 bzw. des natürlichen Oxids 151 eine dotierte Ätzstoppschicht 177 (z.B. ASG, PSG, ...) verwendet, welche insbesondere als Dotierstoffquelle für die Bildung der vergrabenen Platte 165 dient.

Wie in Figur 10a gezeigt, wird zunächst der Graben 108 gebildet, wie bereits oben erläutert. Dann wird nach Entfernen der Hartmaskenschicht 106 auf der Unterbau-Stopschicht 105 und an den Seitenwänden des Grabens 108 z.B. eine ASG-Schicht als Ätzstoppschicht 177 mit einer Dicke von typischerweise 5 bis 30 nm abgeschieden. Anstelle von ASG kann auch PSG oder CVD-Oxid dotiert mit As oder P, z.B. durch PLAD oder Ionenimplantation, verwendet werden.

Optionellerweise wird eine Deckschicht (nicht gezeigt) von 0,5-20 nm Dicke, wie z.B. PECVD-TEOS oder Siliziumnitrid, auf der Oberfläche der ASG-Ätzstoppschicht 177 gebildet, um zu verhindern, daß Dotierstoff aus der ASG-Ätzstoffschicht 177 in das im Graben 108 vorzusehende Opfer-Polysilizium 152 gelangt. Danach wird das Opfer-Polysilizium 152 im Graben und auf der Oberfläche des Wafers abgeschieden. Das Opfer-Polysilizium 152 muß nicht dotiert sein, da es bei diesem Beispiel nicht die Funktion einer Dotierstoffquelle hat, vielmehr sollte es zweckmäßigerweise undotiert sein, was eine höhere Abscheidungsrate ermöglicht.

Allgemein kann die Dicke der dotierten ASG-Ätzstoppschicht 177 je nach Material und Trenchdimension 2-80 nm betragen, wobei sie eine ebene Oberfläche und eine Stufenabdeckung von z.B. 50 % aufweisen sollte. Durch Reduzierung des Abscheidedrucks sind auch höhere Werte für die Stufenabdeckung erreichbar.

Wie in Figur 10b gezeigt, wird dann das Opfer-Polysilizium 152 etwa 0,5 bis 2 µm von der Oberfläche des Substrats 101 zum Definieren des Kragenbereichs eingesenkt, und zwar mittels RIE, CDE oder Naßätzung. Es folgt das Entfernen der ASG-Ätzstoffschicht 177, und zwar beispielsweise durch eine BHF-Naßätzung oder CDE-Ätzung. Falls eine optionale Nitridabdeckschicht verwendet wurde, muß diese vor Entfernen der ASG-Schicht z.B. mit CDE (chemisches Trockenätzen) oder naßchemisch (z.B. HF/Ethylenglykol) entfernt werden.

Anschließend erfolgt die Abscheidung der Kragen-Oxidschicht 167 durch CVD-Oxidbildung mit einer Dicke von 10-60 nm auf den Grabenseitenwänden und der Substratoberfläche oder durch eine thermische Oxidation von 5-10 nm und eine anschließende CVD-Oxidbildung im Dickenbereich von 10-60 nm.

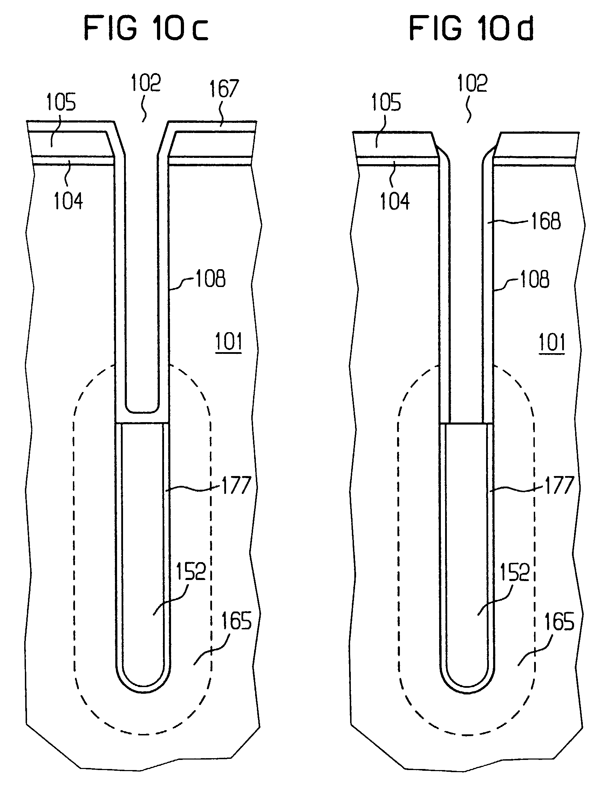

Wie in Figur 10c illustriert, erfolgt anschließend in einem einzigen Prozeßschritt die Verdichtung der Kragen-Oxid-schicht 167 und das Ausdiffundieren der vergrabenen Platte 165 aus der ASG-Ätzstoppschicht 177, beispielsweise bei 1050°C und eine Stunde lang. Falls die Kragen-Oxid-schicht 167 nur durch CVD-Abscheidung gebildet wurde, wird zweckmäßigerweise zunächst eine thermische Oxidation durchgeführt, z.B. bei 900°C und fünf Minuten lang (Sauerstoff diffundiert durch das CVD-Oxid), um ein thermisches Oxid an der Siliziumsubstrat-Kragen-Grenzfläche zu bilden, was die Zuverlässigkeit des zu bildenden Kragens 168 erhöht. Diese thermische Oxidation kann selbstverständlich im gleichen Hochtemperatur-Prozeßschritt wie die Kragenverdichtung und die Diffusion der vergrabenen Platte 165 durchgeführt werden.

Anschließend findet, wie in Figur 10d gezeigt, ein reaktives Ionenätzen zum Ausbilden des eigentlichen Kragens 168 statt.

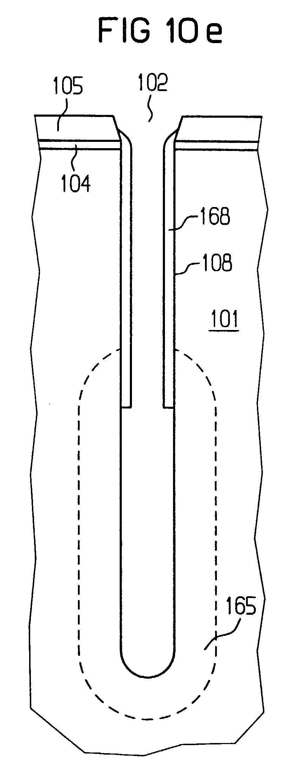

Schließlich erfolgt, wie in Figur 10e gezeigt, ein Entfernen des Opfer-Polysiliziums 152 mittels reaktivem Ionenätzen, CDE-Ätzen oder Naßätzen sowie ein Entfernen der ASG-Ätzstoppschicht 177 durch eine BHF- bzw. DHF-Naßätzung oder CDE-Ätzung. Das Unterbau-Nitrid 105 und das Kragen-Oxid 168 werden dabei ebenfalls geätzt. Dies stellt jedoch kein Problem dar, da deren Dicke wesentlich größer als diejenige der ASG-Ätzstoppschicht 177 ist.

Anschließend werden das Speicherdielektrikum 164 und das Füll-Polysilizium 161 abgeschieden, um zum in Fig. 9c dargestellten Zustand zu gelangen. Dann wird zum Erreichen des in Fig. 6g gezeigten Prozeßstadiums das Füll-Polysilizium 161 eingesenkt, um die vergrabene Brücke 162 zu definieren. Das Speicherdielektrikum 164 und das Kragenoxid 168 werden entfernt, und das Polysilizium bzw. das amorphe Silizium für die vergrabene Brücke 162 wird abgeschieden, planarisiert und eingesenkt. An diesem Punkt fährt das Verfahren fort, wie in bezug auf Fig. 6g bereits beschrieben.

An dieser Stelle sei erwähnt, daß der Prozeßablauf gemäß diesem Beispiel selbstverständlich ebenfalls für einen flaschenförmigen Graben verwendet werden kann, welcher eine erhöhte Grabenkapazität aufweist (vergleiche Figur 7).

Ebenso könnte der Prozeß mit dotierter Ätzstoppschicht und undotiertem Opfer-Polysilizium auch ähnlich, wie in Fig. 8 beschrieben, geführt werden. Die Hartmaskenschicht wird nicht wie in Fig. 7a bereits nach dem Ätzen des Grabens 102 entfernt, sondern erst nach einer wie in Fig. 4e beschriebenen Einsenkung des Opfer-Polysiliziums 161 und der Entfernung des freiliegenden Speicherdielektrikums 164. Diese Vorgehensweise ist dann vorteilhaft, wenn die Polysilizium-Ätzungen (insbesondere der Strip des Opfer-Polysiliziums 161) einen starken Unterbaunitrid-Abtrag verursachen. Allerdings benötigt dieses Verfahren zusätzliche Ätzschritte, was die Herstellungskosten etwas erhöht.

Auch kann die Hartmaskenschicht 106 wahlweise bereits nach dem Ätzen des tiefen Grabens oder erst nach einem ersten Einsenkschritt des Opfer-Polysiliziums 161 und Entfernung des freigeätzten Speicherdielektrikums 164 entfernt werden.

Die Vorteile dieses Beispiels liegen in einem vereinfachten Prozeß zur gleichzeitigen Bildung des Kragens 168 und der vergrabenen Platte 165. Die vergrabene Platte 165 ist selbstjustiert zur Unterseite des Kragens 168 im Gegensatz zu bisher verwendeten Prozessen, bei denen die vergrabene Platte 165 vor Bildung des Oxidkragens durch einen Fotolack-Einsenk-Prozeß gebildet wird (Nesbit et al., s.o.). Nachfolgend wird in der von Nesbit et al. Beschriebenen Variante der Kragen durch eine Polysilizium-Einsenkung gebildet, so daß der Fall eintreten kann, daß die vergrabene Platte und der Oxidkragen zueinander dejustiert sind (z.B. vergrabene Platte sitzt zu tief oder zu hoch und schließt den Auswahltransistor kurz). Dieses Problem wird bei der vorliegenden Erfindung durch selbstjustierende Prozesse gelöst.

Da die Ätzstoppschicht 177 die Dotierstoffquelle für die vergrabene Platte 165 ist, gibt es keine Beschränkungen der Dicke, was wesentlich die einschneidenden Selektivitätserforderniss (Polysilizium gegenüber Oxid) für den Polysilizium-Einsenkprozeß und den Opfer-Polysilizium-Entfernungs-prozeß reduziert. Diese Ätzprozesse sind daher wesentlich einfacher steuerbar.

Als nachteilig bei den oben beschriebenen bekannten Herstellungsverfahren hat sich die Tatache herausgestellt, daß Trokkenätz-Prozeßschritte, wie z.B. das reaktive Ionenätzen des Kragen-Oxids 168 oder des Opfer-Polysiliziums, die Unterbau-Stoppschicht 105 bzw. das Pad-Nitrid ausdünnen, so daß dessen Dicke im voraus entsprechend größer gewählt werden muß. Diese größere Dicke der Unterbau-Stoppschicht 105 macht allerdings die Lithographieschritte für den Graben und die entsprechende Ätzung zur Maskenöffnung schwieriger, weil das Prozeßfenster verkleinert wird. Außerdem wird es beim reaktiven Ionenätzen des Kragen-Oxids 168 mit abnehmender Grabenbreite schwieriger, das Kragen-Oxid 168 von den planaren Flächen im Graben zu entfernen.

Daher ist es Aufgabe der vorliegenden Erfindung, ein verbessertes Herstellungsverfahren für einen Grabenkondensator mit einem Isolationskragen zu schaffen, welches kein reaktives Ionenätzen des Kragen-Oxids erfordert.

Erfindungsgemäß wird diese Aufgabe durch das in Anspruch 1 angegebene Herstellungsverfahren gelöst.

Bevorzugte Weiterbildungen sind Gegenstand der Unteransprüche.

Das erfindungsgemäße Verfahren weist gegenüber den bekannten Lösungsansätzen den Vorteil auf, daß es kein reaktives Ionenätzen des Kragen-Oxids 168 benötigt, sondern eine lokale Bildung des Kragens nur an den Seitenwänden im oberen Bereich des Grabens gewährleistet. Dadurch werden die beim Stand der Technik auftretenden Probleme, wie z.B. Abtrag der Unterbau-Stoppschicht und mangelnde Skalierbarkeit der Kragenätzung für kleiner werdende Gräben vermieden. Als Verfahren zum lokalen Oxidieren bieten sich insbesondere der LOCOS- oder der SELOX-Prozeß an. Nicht zu oxidierende Bereiche auf der Substratoberfläche oder im unteren Bereich des Grabens lassen sich insbesondere durch eine Nitridabdeckung schützen.

Ausführungsbeispiele der vorliegenden Erfindung sind in den Zeichnungen dargestellt und in der nachfolgenden Beschreibung näher erläutert.

In den Figuren zeigen:
- Fig. 1: ein Ausführungsbeispiel einer DRAM-Speicher-zelle gemäß der vorliegenden Erfindung mit LOCOS-Kragen;
- Fig. 2a-h: eine erste Ausführungsform des erfindungsgemäßen Verfahrens zur Herstellung der DRAM-Speicherzelle nach Fig. 1;
- Fig. 3: ein weiteres Ausführungsbeispiel einer DRAM-Speicherzelle gemäß der vorliegenden Erfindung;
- Fig. 4: eine zweite Ausführungsform des erfindungsgemäßen Verfahrens zur Herstellung einer im Vergleich zu Fig. 1 modifizierten DRAM-Speicher-zelle mit SELOX-Kragen;
- Fig. 5: ein Beispiel einer üblichen DRAM-Speicherzelle;
- Fig. 6a-g: Verfahrensschritte eines bekannten Verfahrens zur Herstellung der üblichen DRAM-Speicherzelle nach Fig. 5;
- Fig. 7: ein weiteres Beispiel einer üblichen DRAM-Speicherzelle;
- Fig. 8a-c: ein weiteres Beispiel von Verfahrensschritten eines bekannten Verfahrens zur Herstellung der DRAM-Speicherzelle nach Fig. 5;
- Fig. 9a-c: ein weiteres Beispiel von Verfahrensschritten eines bekannten Verfahrens zur Herstellung der DRAM-Speicherzelle nach Fig. 5; und
- Fig. 10a-e: ein weiteres Beispiel von Verfahrensschritten eines bekannten Verfahrens zur Herstellung der DRAM-Speicherzelle nach Fig. 5.

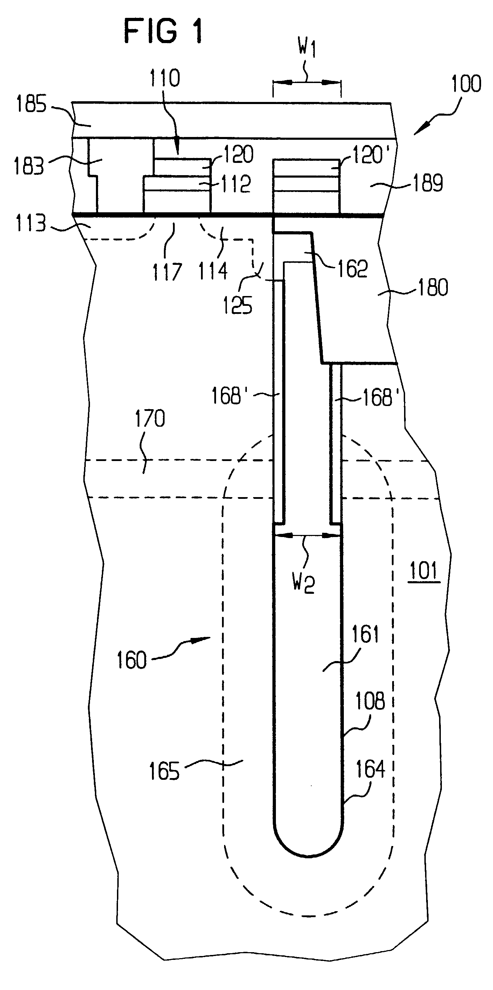

Fig. 1 zeigt ein Ausführungsbeispiel einer DRAM-Speicher-zelle gemäß der vorliegenden Erfindung.

Die in Fig. 1 gezeigte DRAM-Speicherzelle entspricht der in Fig. 5 gezeigten üblichen Speicherzelle mit Ausnahme der Tatsache, daß der Kragen 168' durch einen lokalen thermischen Oxidationsschritt (LOCOS) im oberen Bereich des Grabens 108 selektiv gebildet wurde und daher an seiner Unterseite die dafür typische Vogelschnabelform aufweist.

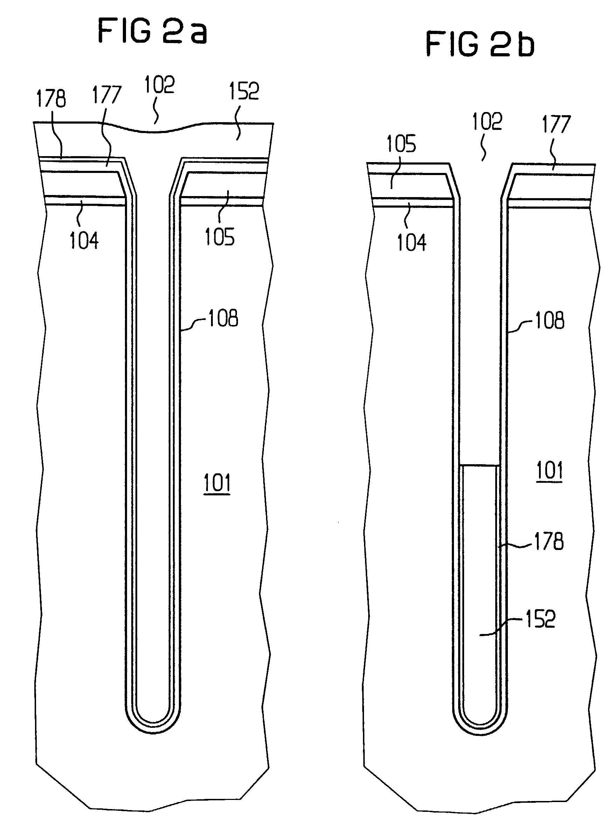

Fig. 2a-h zeigen eine erste Ausführungsform des erfindungsgemäßen Verfahrens zur Herstellung der DRAM-Speicherzelle nach Fig. 1.

Bei dieser ersten Ausführungsform wird wie beim Beispiel nach Fig. 10a-e eine dotierte Ätzstoppschicht 177 (z.B. ASG, PSG, ...) verwendet, welche insbesondere als Dotierstoffquelle für die Bildung der vergrabenen Platte 165 dient.

Wie in Figur 2a gezeigt, wird zunächst der Graben 108 gebildet, wie bereits im Zusammenhang mit dem Stand der Technik erläutert. Dann wird nach Entfernen der Hartmaskenschicht 106 auf der Unterbau-Stopschicht 105 und an den Seitenwänden des Grabens 108 z.B. eine ASG-Schicht als Ätzstoppschicht 177 mit einer Dicke von typischerweise 5 bis 30 nm abgeschieden. Anstelle von ASG kann auch PSG oder CVD-Oxid dotiert mit As oder P, z.B. durch PLAD oder Ionenimplantation, verwendet werden. Ebenso könnte auch eine Diffusion aus der Gasphase (e.g. AsH3, PH3) bei typischerweise 950 - 1050 °C verwendet werden.

Allgemein kann die Dicke der dotierten ASG-Ätzstoppschicht 177 je nach Material und Trenchdimension 2-80 nm betragen, wobei sie eine ebene Oberfläche und eine Stufenabdeckung von z.B. 50 % aufweisen sollte. Durch Reduzierung des Abscheidedrucks sind auch höhere Werte für die Stufenabdeckung erreichbar.

Darauf wird eine Nitrid- oder Oxinitrid-Deckschicht 178 von 5-30 nm Dicke je nach Ätzselektivität, z.B. mittels CVD (LPCVD, PECVD), auf der Oberfläche der ASG-Ätzstoppschicht 177 gebildet, um einerseits als Maske bei der späteren lokalen Kragen-Oxidationsschritt zu dienen und anderseits zu verhindern, daß Dotierstoff aus der ASG-Ätzstoffschicht 177 in das im Graben 108 vorzusehende Opfer-Polysilizium 152 gelangt.

Danach wird das Opfer-Polysilizium 152 im Graben und auf der Oberfläche des Wafers abgeschieden. Das Opfer-Polysilizium 152 muß nicht dotiert sein, da es bei diesem Beispiel nicht die Funktion einer Dotierstoffquelle hat, vielmehr sollte es zweckmäßigerweise undotiert sein, was eine höhere Abscheidungsrate ermöglicht.

Wie in Figur 2b gezeigt, wird dann das Opfer-Polysilizium 152 etwa 0,5 bis 2 µm von der Oberfläche des Substrats 101 zum Definieren des Kragenbereichs eingesenkt, und zwar mittels RIE, CDE oder Naßätzung selektiv zu Oxid und Nitrid.

Es folgt das Entfernen der Deckschicht 178 im Kragenbereich, und zwar beispielsweise durch CDE (chemisches Trockenätzen) mit CF₄/O₂/N₂ oder naßchemisch mit HF/Ethylenglykol.

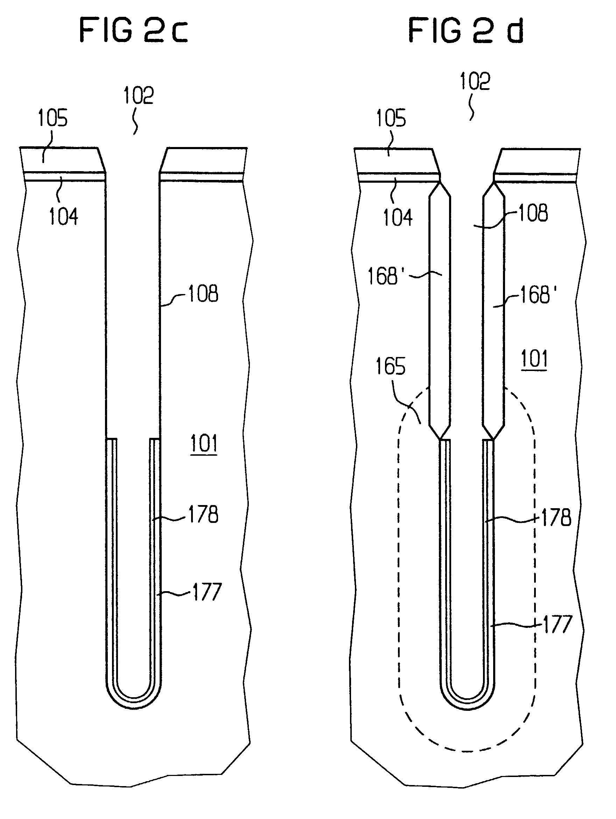

Danach erfolgt, wie in Figur 2c gezeigt, ein Entfernen des Opfer-Polysiliziums 152 mittels reaktivem Ionenätzen, CDE-Ätzen oder Naßätzen im unteren Grabenbereich selektiv zur Unterbau-Stoppschicht 105, zur ASG-Ätzstoppschicht 177 und zur Deckschicht 178. Dann wird die ASG-Ätzstoppschicht 177 durch eine BHF- bzw. DHF-Naßätzung oder CDE-Ätzung im Kragenbereich selektiv zur Unterbau-Stoppschicht 105 und zur Deckschicht 178 entfernt.

Anschließend erfolgt, wie in Fig. 2d gezeigt, die Abscheidung der Kragen-Oxidschicht 168' lokale thermische Oxidation (LOCOS) z.B. bei 1050 °C eine Stunde lang mit einer Dicke von 20 - 40 nm, um die typische Vogelschnabelform zu ergeben. Dabei erfolgt zweckmäßigerweise in einem einzigen Prozeßschritt das Ausdiffundieren der vergrabenen Platte 165 aus der ASG-Ätzstoppschicht 177.

Damit entfällt das reaktive Ionenätzen zum Ausbilden des eigentlichen Kragens 168, das beim oben erwähnten Stand der Technik erforderlich ist und die genannten Nachteile mit sich bringt.

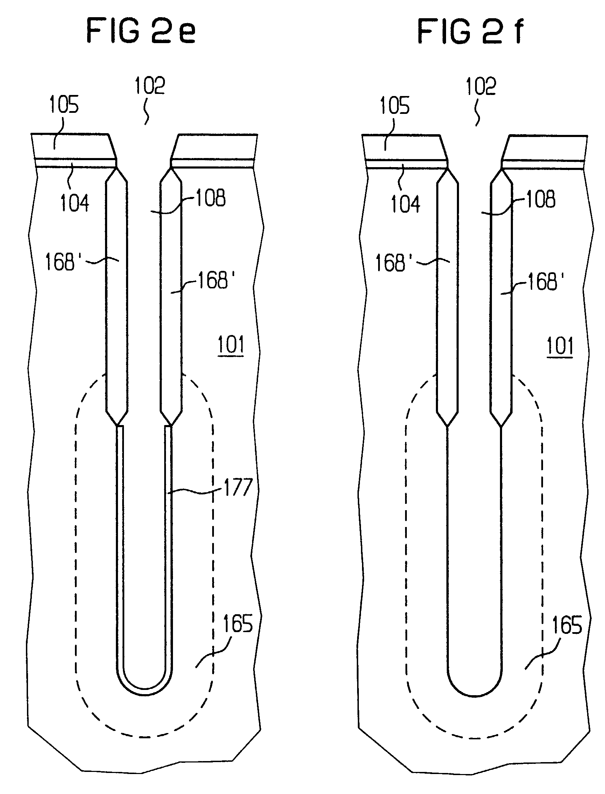

Als nächstes wird, wie in Fig. 2e gezeigt, die Deckschicht 178 im unteren Bereich des Grabens 108 entfernt, und zwar beispielsweise durch CDE (chemisches Trockenätzen) mit CF₄/O₂/N₂ oder naßchemisch mit HF/Ethylenglykol. Dieses Entfernen der Deckschicht 178 geschieht selektiv zum Kragenoxid 168' oder mit geringerer Selektivität mit z.B. HF/ Ethylenglykol, wobei der Kragen dann entsprechend dicker gemacht werden muß (typischerweise 5nm).

Danach wird, wie in Fig. 2f illustriert, die ASG-Ätzstoppschicht 177 durch eine BHF- bzw. DHF-Naßätzung oder CDE-Ätzung im unteren Bereich des Grabens 108 möglichst selektiv zur Unterbau-Stoppschicht 105 und zum Kragenoxid 168' entfernt. Dazu sei benerkt, daß keine sehr hohe Selektivität bei diesem Prozeßschritt erzielbar ist, also die Unterbau-Stoppschicht 105 und das Kragenoxid 168' ebenfalls geätzt werden. Da die Dicke der ASG-Ätzstoppschicht typischerweise nur 5 - 10 nm auf der Grabenseitenwand beträgt, während die Dicke des Kragenoxids typischerweise 20 - 40 nm beträgt und die Unterbau-Stoppschicht 100 - 200 dick ist, ist ein Ätzabtrag der Unterbau-Stoppschicht 105 und des Kragenoxids 168' um einige (z.B. 5 -10) nm bei diesem Schritt tolerabel.

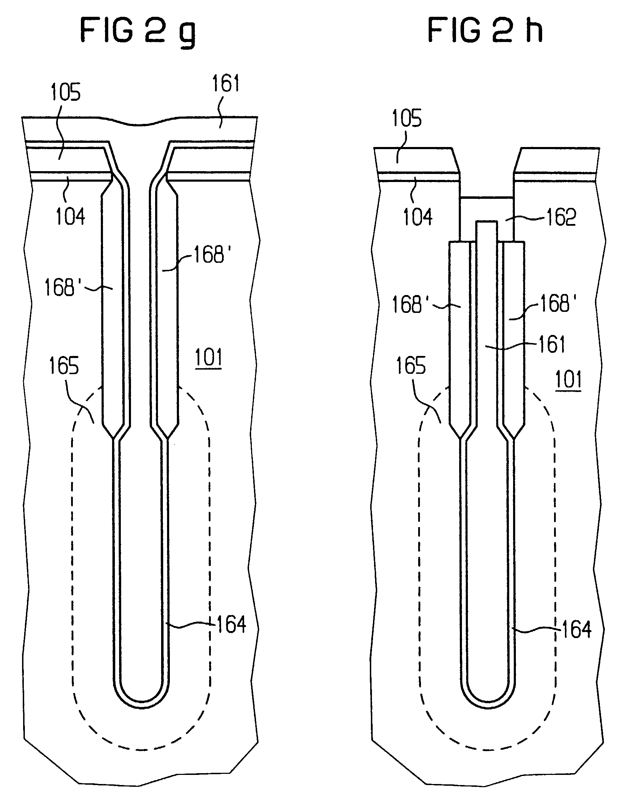

Gemäß Fig. 2g werden das Speicherdielektrikum 164 und das As- oder P-dotierte Füll-Polysilizium 161 abgeschieden.

Dann wird zum Erreichen des in Fig. 2h gezeigten Prozeßstadiums das Füll-Polysilizium 161 eingesenkt, um die vergrabene Brücke 162 zu definieren. Das Speicherdielektrikum 164 und das Kragenoxid 168 werden entfernt, und das Polysilizium bzw. das amorphe Silizium für die vergrabene Brücke 162 wird abgeschieden, planarisiert und eingesenkt. An diesem Punkt fährt das Verfahren fort, wie in bezug auf Fig. 6g im Zusammenhang mit dem Stand der Technik bereits beschrieben.

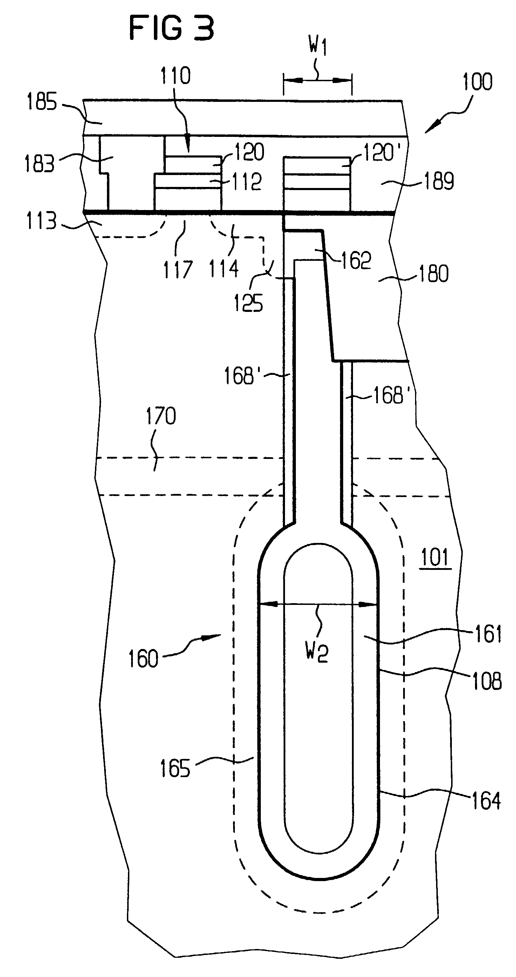

An dieser Stelle sei erwähnt, daß der Prozeßablauf gemäß diesem Beispiel selbstverständlich ebenfalls für einen flaschenförmigen Graben verwendet werden kann, welcher eine erhöhte Grabenkapazität aufweist, wie in Figur 3 angedeutet.

Gemäß einer weiteren (nicht illustrierten) Ausführungsform könnte eine undotierte ASG-Ätzstoppschicht verwendet werden und dann optionellerweise die vergrabene Platte 165 nach Entfernen der undotierten ASG-Ätzstoppschicht im unteren Bereich des Grabens 108 vorgesehen werden.

Insbesondere könnte dies durch eine Gasphasendotierung mit AsH₃ oder PH₃, eine Plasmadotierung (PLAD) oder einen PIII(Plasma Immersion Ion Implantation)-Prozeß oder eine übliche Ionenimplantation geschehen.

Eine übliche Ionenimplantation könnte sogar vor Entfernen der Ätzstoppschicht oder der Deckschicht durchgeführt werden, um diese Schicht(en) als Streuschichten zu nutzen.

Bei einer Plasmadotierung (PLAD) oder einem PIII(Plasma Immersion Ion Implantation)-Prozeß oder einer übliche Ionenimplantation kann ein zusätzlicher Drive-in-Annealschritt notwendig sein, wie z.B bei 1000 °C eine Stunde lang in N₂-Atmosphäre.

Allgemein sieht diese erste Ausführungsform vor, einen Isolationskragen durch eine lokale Oxidation auf Silizium zu bilden und eine optionelle vergrabene Platte selbstausrichtend zum LOCOS-Kragen unter Verwendung einer Polysilizium-Einsenkung anstelle eines Lackprozesses, was eine bessere Einsenkungskontrolle ermöglicht. Die Einsenkungskontrolle ist wichtig, um den vertikalen parasitären Feldeffekttransistor mit dem Kragen als Gate unter allen Umständen geschlossen zu halten. Ein Deckschicht im unteren Bereich des Grabens und die Unterbau-Stoppschicht, die ebenfalls vorzugsweise aus Nitrid ist, sorgen dafür, daß das LOCOS-Oxid nur im oberen Bereich des Grabens aufwächst, um den fertigen Kragen zu bilden.

Eine gewisse Problematik ergibt sich beim LOCOS-Kragen durch Versetzungsbildung durch thermischen Oxidstress und einer daraus resultierenden variablen Haltezeit (retention time). Auch gibt es Dickenschwankungen entlang des Umfangs, da die Wachtumsrate des Oxid von der kristallographischen Richtung abhängig ist.

Fig. 4 zeigt eine zweite Ausführungsform des erfindungsgemäßen Verfahrens zur Herstellung einer im Vergleich zu Fig. 1 modifizierten DRAM-Speicherzelle mit einem SELOX-Kragen.

Dabei entspricht Fig. 4 dem in Fig. 2d dargestellten Prozeßstadium, wobei bei dieser zweiten Ausführungsform eine Kragen-Oxidschicht 168" durch selektive Abscheidung von CVD-Oxid (SELOX-Prozeß) vorgesehen ist. Neben den Vorteilen der ersten Ausführungsform bringt dies den speziellen Vorteil, daß eine Versetzungsbildung, wie sie beim LOCOS-Prozeß infolge von mechanischen Spannungen im Kragenbereich auftreten kann, minimiert ist, da ein CVD-Oxid-Kragen verwendet wird. Auch ist die Dicke beim selektiven CVD-Prozeß gleichmäßiger, da weniger kristallographische Variationen in der Schicht auftreten. Schließlich ist die Aufweitung des oberen Grabenbereichs um typischerweise 5 nm im Vergleich zum LOCOS-Prozeß um typischerweise 30 nm wesentlich geringer.

Insbesondere ist der SELOX-Prozeß in der US-A-5,399,389 von Gabric offenbart und sieht folgende allgemeine Vorgehensweise vor. Zunächst werden werden Precursor-Schichten mit verschiedenen Wachstumsraten für SiO₂ auf Oberflächen verschiedener Höhe vorgesehen. Dann wird auf diesen Oberflächen eine Ozonaktivierte CVD-Abscheidung von SiO₂ durchgeführt, wobei das Wachstum der SiO₂-Schicht auf niedriger liegenden Oberflächen schneller ist als auf höher liegenden Oberflächen. Letztlich werden die Oberflächen durch Fortführen des Prozesses, bis ein planarer Pegel erreicht ist, angeglichen. Für weitere Einzelheiten der Prozeßführung sei auf die US-A-5,399,389 verwiesen.

Aus N. Elbel et al., "A NEW STI Process Based on Selective Oxide Deposition", 1998 Symposium on VLSI Technology Digest of Technical Papers, IEEE, p. 21.2 ff., sind weitere Einzelheiten zum SELOX-Prozeß entnehmbar.

Insbesondere wird das Kragen-Oxid 168" im Kragenbereich selektiv zur Unterbau-Stoppschicht 105 und zur Deckschicht 178 mit einer Dicke von typischerweise 50 nm abgeschieden. Im Vergleich dazu beträgt die Dicke auf der Unterbau-Stopp-schicht 105 und auf der Deckschicht 178 typischerweise nur 10 nm oder weniger.

Das Rückätzen des Oxids von der Unterbau-Stoppschicht 105 und der Deckschicht 178 kann danach beispielsweise mit einer isotropen Naßätzung mit BHF erfolgen, und zwar vorzugsweise vor einer Verdichtung des Kragens in einem Hochtemperaturschritt.

Auch ist es möglich, die Kragen-Abscheidung, die Verdichtung und das Eintreiben der vergrabenen Platte 165 in einem gemeinsamen Prozeßschritt, z.B bei 900 °C 5 Minuten lang mit O₂-Zugabe und bei 1050 °C 30 Minuten lang mit N₂-Zugabe durchzuführen und danach erst das Rückätzen.

Das Entfernen der Schichten 177 und 178 erfolgt, wie bei der ersten Ausführungsform beschrieben, beispielsweise durch einen HF/Ethylenglykol-Ätzschritt.

Bei einem sehr selektiven Oxidationsschritt mit einer Selektivität von z.B. 80:1 kann der Rückätzschritt sogar ganz entfallen.

Eine weitere Alternative ist eine Kombination des Rückätzens mit dem Entfernen der Schichten 177 und 178 in einem einzigen Trockenätzschritt.

Der zurückbleibende Kragen sollte dann typischerweise eine Dicke von 30 nm aufweisen.

Ansonsten entsprechen die Prozeßschritte der zweiten Ausführungsform denen der mit Bezug auf Fig. 2a-h erläuterten ersten Ausführungsform.

An dieser Stelle sei erwähnt, daß der Prozeßablauf gemäß dieser zweiten Ausführungsform selbstverständlich ebenfalls für einen flaschenförmigen Graben verwendet werden kann, welcher eine erhöhte Grabenkapazität aufweist, wie in Figur 3 angedeutet.

Weiterhin könnte auch bei der zweiten Ausführungsform eine undotierte ASG-Ätzstoppschicht verwendet werden und dann optionellerweise die vergrabene Platte 165 nach Entfernen der undotierten ASG-Ätzstoppschicht im unteren Bereich des Grabens 108 vorgesehen werden, wie bereits oben im Zusammenhang mit der ersten Ausführungsform ausführlich erläutert.

Gemäß einer weiteren (nicht illustrierten) Ausführungsform könnte bei der ersten und vorzugsweise bei der zweiten Ausführungsform das Opfer-Füllmaterial z.B. Fotolack anstelle von Polysilizium oder ein anderes geeignetes Füllmaterial sein. In diesem Fall müßten die entsprechenden Einsenk- und Entfernungsschritte geeignet angepaßt werden. Bei Fotolack wäre z.B. eine CDE-Ätzung oder eine Naßätzung mit H₂SO₄/H₂O₂ angebracht.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere sind die angeführten Materialien nur beispielhaft und durch andere Materialien mit geeigneten Eigenschaften ersetzbar. Dasgleiche gilt für die genannten Ätzprozesse und Abscheidungsprozesse.

Auch sind alle gezeigten Ausführungsformen miteinander kombinierbar, was die Materialien und die Abfolge der Prozeßschritte betrifft.

## Patentansprüche

1. Verfahren zur Herstellung eines Grabenkondensators, insbesondere zur Verwendung in einer Halbleiter-Speicher-zelle (100), mit einem Isolationskragen (168'; 168") mit den Schritten:
Bereitstellen eines Substrats (101);
Bilden eines Grabens (108) in dem Substrat (101);
Vorsehen einer ersten Schicht (177) auf der Grabenwand;
Vorsehen einer zweiten Schicht (178) auf der ersten Schicht (177) auf der Grabenwand;
Füllen des Grabens (108) mit einem ersten Füllmaterial (152);
Entfernen des ersten Füllmaterials (152) aus dem oberen Bereich des Grabens (108) zum Definieren eines Kragenbereichs;
Entfernen der zweiten Schicht (178) aus dem oberen Bereich des Grabens (108);
Entfernen des ersten Füllmaterials (152) aus dem unteren Bereich des Grabens (108);
Entfernen der ersten Schicht (177) aus dem oberen Bereich des Grabens (108);
lokales Oxidieren des oberen Bereichs des Grabens (108) zum Schaffen des Isolationskragens (168'; 168");
Entfernen der ersten und zweiten Schicht (177; 178) aus dem unteren Bereich des Grabens;
Bilden einer dielektrischen Schicht (164) im unteren Bereichs des Grabens (108) und auf der Innenseite des Isolationskragens (168'; 168"); und
Füllen des Grabens (108) mit einem leitenden zweiten Füllmaterial (161).

2. Verfahren nach Anspruch 1, **gekennzeichnet durch** den Schritt des Bildens einer vergrabenen Platte (165) im Substrat (101) in der Umgebung des unteren Bereichs des Grabens (108).

3. Verfahren nach Anspruch 2, **dadurch gekennzeichnet,** daß das Bilden der vergrabenen Platte (165) selbstjustierend zum Isolationkragen erfolgt.

4. Verfahren nach Anspruch 3, **dadurch gekennzeichnet,** daß das Bilden der vergrabenen Platte (165) durch Ausdiffusion aus der ersten Schicht (177) durchgeführt wird.

5. Verfahren nach Anspruch 4, **dadurch gekennzeichnet,** daß das Bilden der vergrabenen Platte (165) durch Ausdiffusion aus der ersten Schicht (177) gleichzeitig mit dem Oxidieren und/oder einem Verdichten des Kragens (168'; 168") durchgeführt wird.

6. Verfahren nach Anspruch 3, **dadurch gekennzeichnet,** daß das Bilden der vergrabenen Platte (165) in einem separaten Schritt durch Gasphasendotierung, PLAD, PIII oder Ionenimplantation durchgeführt wird.

7. Verfahren nach einem der vorhergehenden Ansprüche, **dadurch gekennzeichnet,** daß das lokale Oxidieren des oberen Bereichs des Grabens (108) zum Schaffen des Isolationskragens (168'; 168") durch eine selektive lokale SELOX-Oxidation erfolgt.

8. Verfahren nach einem der vorhergehenden Ansprüche, **dadurch gekennzeichnet,** daß das lokale Oxidieren des oberen Bereichs des Grabens (108) zum Schaffen des Isolationskragens (168'; 168") durch eine thermische LOCOS-Oxidation erfolgt.

9. Verfahren nach einem der vorhergehenden Ansprüche, **dadurch gekennzeichnet,** daß als das erste Füllmaterial (152) Polysilizium oder Photolack verwendet wird.

10. Verfahren nach einem der vorhergehenden Ansprüche, **gekennzeichnet durch** den Schritt des Erweiterns des unteren Bereichs des Grabens (108) gegenüber dem oberen Bereich des Grabens (108) zum Bilden einer Flaschenform.

11. Verfahren nach einem der vorhergehenden Ansprüche, **dadurch gekennzeichnet,** daß als die zweite Schicht (178) eine nitridhaltige Schicht verwendet wird.

12. Verfahren nach einem der vorhergehenden Ansprüche, **dadurch gekennzeichnet,** daß auf der Oberseite des Substrats (101) eine vorzugsweise nitridhaltige Schicht (105) zum Definieren der Grabenöffnung vorgesehen wird.
